Europäisches Patentamt

European Patent Office

Office européen des brevets

(19)

(11) **EP 1 332 650 B1**

(12) **FASCICULE DE BREVET EUROPEEN**

(45) Date de publication et mention
de la délivrance du brevet:
**04.01.2006 Bulletin 2006/01**

(51) Int Cl.:
*H05H 1/44* (2006.01)    *H05H 1/24* (2006.01)

(21) Numéro de dépôt: 01980831.0

(22) Date de dépôt: **12.11.2001**

(86) Numéro de dépôt international:
**PCT/IB2001/002121**

(87) Numéro de publication internationale:
**WO 2002/039791 (16.05.2002 Gazette 2002/20)**

(54) **PROCEDE DE TRAITEMENT PAR PLASMA ATMOSPHERIQUE DE MATERIAUX CONDUCTEURS D'ELECTRICITE ET DISPOSITIF POUR SA MISE EN OEUVRE**

VERFAHREN ZUR BEHANDLUNG VON ELEKTRISCH LEITFÄHIGEN MATERIALIEN DURCH ATMOSPHÄRISCHES PLASMA UND VORRICHTUNG DAZU

ATMOSPHERIC PLASMA METHOD FOR TREATING SHEET ELECTRICITY CONDUCTING MATERIALS AND DEVICE THEREFOR

(84) Etats contractants désignés:
**AT BE CH CY DE DK ES FI FR GB GR IE IT LI LU MC NL PT SE TR**

(30) Priorité: **10.11.2000 EP 00811065**

(43) Date de publication de la demande:
**06.08.2003 Bulletin 2003/32**

(60) Demande divisionnaire:
**05021750.4**

(73) Titulaire: **Apit Corp. SA
1950 Sion (CH)**

(72) Inventeurs:
• **KOULIK, Pavel
F-67113 Blaesheim (FR)**
• **SAITCHENKO, Anatolii
F-67400 Illkirch-Graffenstaden (FR)**

• **MUSIN, Nail
F-67400 Illkirch-Graffenstaden (FR)**

(74) Mandataire: **Reuteler, Raymond Werner
WILLIAM BLANC & CIE,
Conseils en Propriété Industrielle SA,
25, Avenue du Pailly
1220 Les Avanchets/Genève (CH)**

(56) Documents cités:
**EP-A- 0 630 087       WO-A-97/18694
US-A- 3 050 616        US-A- 3 989 512**

• **PATENT ABSTRACTS OF JAPAN** vol. 1999, no. 09, 30 juillet 1999 (1999-07-30) & JP 11 106947 A (NKK CORP), 20 avril 1999 (1999-04-20)
• **PATENT ABSTRACTS OF JAPAN** vol. 1999, no. 13, 30 novembre 1999 (1999-11-30) & JP 11 222530 A (NITTO DENKO CORP), 17 août 1999 (1999-08-17)

EP 1 332 650 B1

## Description

La présente invention concerne un procédé de traitement par plasma d'objets en matériaux conducteurs d'électricité. L'invention concerne notamment le traitement par plasma atmosphérique d'objets sous forme de feuilles ou de fils, par exemple après leur laminage ou effilage.

Le traitement d'un matériau peut comprendre une ou plusieurs des opérations suivantes :

- Nettoyage d'une ou des deux faces d'une feuille ou d'un fil, des résidus organiques et des huiles et graisses technologiques.
- Désodorisation.
- Désinfection, stérilisation.
- Activation de la surface pour l'amélioration des propriétés d'adhésion ou de mouillabilité.
- Modification de la couche superficielle pour la fusion des microfissures, le polissage ou la formation d'un alliage superficiel.
- Décapage.
- Recuit, élimination des tensions internes.
- Dépôt de films.

Il est connu d'utiliser des procédés et dispositifs pour le nettoyage des surfaces de feuilles laminées ou de fils pour en éliminer les restes de graisses utilisées dans leur fabrication. Les dispositifs de traitement les plus répandus sont les fours à diffusion, les brûleurs à gaz, les bains chimiques, les jets de vapeur d'eau, les dispositif à décharges électriques du type barrière ou décharges silencieuses, et les dispositifs à jets de plasma.

Les inconvénients des fours à diffusion, pour le nettoyage des feuilles métalliques, qu'ils soient à air ou à oxygène, sont qu'ils nécessitent de grandes puissances électriques et ont un effet très lent. Il faut plusieurs jours, voire semaines, pour que des feuilles, qui sont normalement chargées dans le four sous forme de rouleaux, soient complètement nettoyées. Le processus consiste à réchauffer le rouleau, à faire pénétrer l'air ou l'oxygène entre les couches de feuilles pour oxyder le résidu organique, et à évacuer, principalement par diffusion, le gaz résiduel entre les couches de feuilles serrées les unes aux autres dans le rouleau. La productivité et l'efficacité de tels fours sont donc faibles. Les fours à diffusion ne sont utilisés que pour le nettoyage et le recuit de matériaux.

Les brûleurs linéaires à flamme sont peu employés en raison de leur faible rendement et les variations limitées de la composition de la flamme contenant des produits carboniques. Les brûleurs à flamme ne sont généralement utilisés que pour le nettoyage et le recuit de matériaux.

Les bains chimiques utilisent des produits chimiques en grande quantité, ces produits devant être recyclés. Le processus est limité par le prix élevé du recyclage et la nécessité de satisfaire aux normes écologiques de plus en plus strictes.

Les jets de vapeurs sont utilisés pour le nettoyage des fils. Ce nettoyage, vu son caractère peu efficace, n'est utilisé, pratiquement, que pour une opération préliminaire de dégrossissage, suivie généralement d'un nettoyage chimique.

L'utilisation de décharges de type barrières ou silencieuses, qui aurait l'avantage d'un traitement uniforme du matériau, n'est pas convenable pour les procédés industriels en raison de la productivité limitée de ces procédés.

Le traitement par jets de plasma atmosphérique est relativement efficace puisque ce traitement se fait par un gaz hautement activé et l'oxydation résulte d'une réaction plasmochimique. D'autre part, la productivité est élevée en raison de la haute densité de puissance atteignable. Les dispositifs pour le traitement par jets de plasma sont généralement simples, peu coûteux et flexibles. Par ailleurs, on peut effectuer un nettoyage de la surface, un recuit, un décapage ou un dépôt de film, la composition des gaz du plasma étant adaptée au traitement à effectuer.

Un désavantage des procédés par jets de plasma est qu'il est difficile d'obtenir un traitement uniforme sur toute la surface de la feuille ou du fil.

Pour remédier à ce désavantage, certains auteurs ont tenté de concevoir des dispositifs utilisant des ensembles linéaires de plasmatrons pour créer des rideaux de plasmas.

Par exemple, dans la publication WO97/18693 on décrit un générateur de plasma générant un plasma ayant la forme d'un rideau en superposant plusieurs jets issus de plusieurs plasmatrons à deux buses. L'inconvénient de ce procédé est que la distribution uniforme voulue des paramètres, tels que la température, n'est pas réalisable pour la majorité des applications industrielles intéressantes. En effet, le débit de gaz à travers les plasmatrons et la distribution des vitesses ne permettent pas d'obtenir, dans tous les cas, la distribution uniforme voulue des paramètres. Même si la température est uniforme sur toute la longueur du rideau, il ne s'en suit pas nécessairement que la vitesse et/ou la composition du plasma seront uniformes, ce qui provoque une non-uniformité du traitement.

En outre, étant donné que l'utilisation de ce type de générateur linéaire de plasma pour le traitement de feuilles métalliques nécessite un passage rapide de la feuille à travers le rideau de plasma, un flux important de gaz ou d'air est entraîné par la feuille en mouvement. Ce flux de gaz, turbulent, interfère avec le flux de plasma, ce qui a comme conséquence que le plasma est refroidi, perd son énergie accumulée sous forme d'énergie potentielle de ses particules, et devient turbulent. L'efficacité du traitement est fortement diminuée par le refroidissement. La turbulence peut occasionner des déformations de la feuille traitée, telles que le chiffonnement, surtout quand il s'agit de feuilles de faible épaisseur.

US 3,989,512 décrit un procédé de traitement thermique par plasma et un dispositif pour la mise en oeuvre du procédé, le dispositif ayant des jets de plasma anodiques et cathodiques pour former une colonne de plasma dans lequel des poudres sont injectées afin de soumettre ces poudres à un traitement thermique.

JP 11106947 décrit un procédé de traitement par plasma d'une feuille pour un traitement par plasma à basse température. Le plasma est créé par micro-ondes dans le vide.

Un but de la présente invention est d'améliorer l'uniformité de traitement d'un procédé de traitement par plasma, notamment pour des applications industrielles de traitement d'objets ayant des grandes surfaces, notamment des feuilles ou d'objets tels que les fils, nécessitant de très grandes vitesses de traitement, et de fournir un dispositif pour la mise en oeuvre de ces procédés.

Il est avantageux de réaliser un procédé de traitement par plasma et un dispositif pour sa mise en oeuvre, apte notamment à être utilisé pour le traitement des feuilles ou des fils de matériaux conducteurs qui est fiable, rapide et économe.

Il est en outre avantageux de réaliser un procédé et un dispositif pour sa mise en oeuvre qui peut effectuer une opération ou une combinaison d'opérations telles que le nettoyage, le recuit, le dépôt de films, l'activation de la surface, le décapage et la stérilisation.

Des buts de l'invention sont réalisés par un procédé selon la revendication 1 et un dispositif selon la revendication 21 pour la mise en oeuvre du procédé.

Dans la présente invention, un procédé de traitement par plasma atmosphérique d'un objet à traiter en un matériau conducteur d'électricité, comprend la génération de jets de plasma par des générateurs de plasma, l'application des jets de plasma sur une surface à traiter de l'objet à traiter, et le déplacement relatif de l'objet à traiter par rapport au générateurs de plasma, caractérisé en ce que au moins un des jets de plasma est un jet cathodique et au moins un des jets de plasma est un jet anodique, le jet anodique étant appliqué dans une zone de traitement sur ladite surface à traiter à proximité du jet cathodique. Le procédé selon l'invention peut avantageusement être appliqué à des objets fabriqués en continue ou ayant des grandes surfaces telles que des feuilles ou fils métalliques ou des tôles, par exemple de carrosseries d'automobiles.

Le courant électrique pour la génération des jets cathodique et anodique de plasma est divisé en trois parties, l'une $I_3$ passant par l'objet à traiter et les deux autres $I_1$, $I_2$ servant à alimenter les jets anodique et cathodique de plasma.

Avantageusement, le jet cathodique forme un angle $\alpha$ aigu avec la surface à traiter et le jet anodique forme avec la surface à traiter un angle $\beta$ qui est plus grand que angle $\alpha$ formé entre le jet cathodique et la surface à traiter. Dans une variante, l'angle $\beta$ entre le jet anodique et la surface à traiter approche, ou est essentiellement égal à 90° et l'angle $\alpha$ formé entre le jet cathodique et la surface à traiter est entre 25° et 60°.

De préférence l'impulsion des jets cathodiques a une puissance supérieure à celle des jets anodiques.

Le procédé selon l'invention permet d'obtenir une bonne uniformité du traitement du fait qu'il génère un mouvement spécial des taches anodiques le long de la surface à traiter. Le mouvement des taches anodiques permet de diminuer l'influence de la couche limite formée sur la surface traitée. L'uniformité du traitement est améliorée par la délocalisation des taches anodiques due à l'échauffement de la couche limite, d'une part, et d'autre part en raison du déplacement des taches sous l'influence de leur champ magnétique propre. La délocalisation transversale du courant électrique permet de distribuer transversalement le traitement thermique et plasmochimique de manière uniforme sur toute la surface traitée.

L'utilisation des taches cathodiques et anodiques dans le procédé même de traitement de la feuille ou du fil par le plasma permet d'augmenter le rendement thermique du processus.

Le dispositif pour la mise en oeuvre du procédé selon l'invention comporte au moins un générateur de jet de plasma cathodique et au moins un générateur de jet de plasma anodique disposés de manière à ce que le jet anodique est appliqué dans une zone de traitement sur la surface à traiter à proximité du jet cathodique.

Le circuit électrique du dispositif pour l'alimentation des jets de plasma, comprend un boucle qui est fermé par une partie de l'objet à traiter, et un moyen pour varier le courant électrique $I_3$ circulant dans l'objet à traiter.

Les jets de plasma peuvent êtres inclinés d'un angle aigu $\gamma$ par rapport à la direction du déplacement relatif de l'objet à traiter par rapport au générateurs de plasma pour augmenter la surface d'application du plasma contre la surface à traiter pour obtenir une bonne uniformité de traitement transversale.

On peut aussi obtenir une bonne uniformité de traitement transversale en générant un champ magnétique alternatif de manière que les forces d'Ampère résultantes provoquent une oscillation balayante des jets de plasma. La fréquence $\nu$ d'oscillations du champ magnétique est de préférence égale ou supérieure au rapport de la vitesse relative de déplacement de l'objet à traiter au diamètre des jets de plasma.

Le dispositif de traitement peut avantageusement comporter un ou plusieurs jets de gaz réactif dirigés sur les jets de plasma de manière à élargir et à comprimer les jets de plasma contre l'objet à traiter et ainsi améliorer l'uniformité de traitement.

Selon un aspect avantageux de l'invention, on génère une vibration acoustique ou ultrasonique sur l'objet à traiter pendant l'application du plasma, par un générateur de vibrations externe ou par un processus de génération du plasma créant par exemple des ondes de choc ou des ondes acoustiques à des fréquences proches des fréquences résonantes de l'objet à traiter. Des ondes de choc peuvent être créées en générant du plasma par impulsions d'alimentation électrique où la durée du front de croissance de l'amplitude du courant des impulsions d'alimentation électrique est assez courte pour que le processus de croissance de l'amplitude de courant soit isochorique. La fréquence des impulsions d'alimentation électrique est de préférence proche ou égale à la fréquence des vibrations acoustiques.

Dans une forme d'exécution pour le traitement de fils, les jets cathodiques et anodiques peuvent être disposés sous forme d'entonnoir le long de l'axe duquel se déplace le fil traité.

Dans une forme d'exécution pour le traitement de feuilles, l'installation de traitement peut être munie, en amont de la zone d'application de plasma, d'un dispositif de stabilisation de courants d'air comprenant des déflecteurs qui peuvent être actionné par un mécanisme permettant le réglage de leurs positions et donc le dosage de la quantité d'air séparée de la feuille à traiter. Le dispositif peut aussi être muni, en aval de la zone d'application de plasma, de déflecteurs laminarisants refroidis.

Avantageusement, la laminarisation du flux d'air entraîné par la feuille à traiter permet d'éviter le chiffonnement de la feuille et augmente sensiblement l'efficacité du traitement par plasma.

Dans la direction transversale de la feuille ou du fil à traiter, les générateurs cathodiques et anodiques peuvent être alternés de manière que l'axe de chacun des générateurs d'un pôle donné soit équidistant des axes des deux générateurs voisins, tous deux de pôle opposé.

L'installation de traitement peut avoir deux générateurs identiques de plasma, disposés de part et d'autre de la feuille de matériau conducteur, de manière à traiter simultanément ou consécutivement les deux faces de cette feuille.

D'autres buts et caractéristiques avantageuses de l'invention ressortiront des revendications, de la description des formes d'exécution de l'invention ci-après et des dessins annexés, dans lesquels:

la Fig. 1 est une vue en perspective, simplifiée, d'une installation de traitement de feuilles comprenant des dispositifs de traitement par plasma selon l'invention;

la Fig. 2 est une vue en coupe, simplifiée, d'une installation de traitement de feuille comprenant des dispositifs de traitement par plasma selon l'invention;

la Fig. 3 est une vue en coupe, simplifiée, d'un dispositif de traitement par jets de plasma selon l'invention;

la Fig. 4a est une vue de face dans une direction parallèle au plan d'une feuille à traiter montrant l'arrangement des électrodes et des jets de plasma;

la Fig. 4b est une vue dans la direction de la flèche IVb de la Fig. 4a;

la Fig. 4c est une vue dans une direction perpendiculaire au plan d'une feuille à traiter montrant l'arrangement des électrodes et des jets de plasma selon une variante de la forme d'exécution montrée dans la figure 4b;

la Fig. 4d est une vue dans la direction de la flèche IVd de la Fig. 4c;

la Fig. 4e est une vue dans une direction parallèle au plan d'une feuille à traiter montrant l'arrangement des électrodes et des jets de plasma de part et d'autre de la feuille selon une forme d'exécution de l'invention;

la Fig. 4f est une vue dans une direction parallèle au plan d'une feuille à traiter montrant l'arrangement des électrodes et des jets de plasma de part et d'autre de la feuille selon une variante de la forme d'exécution montrée dans la figure 4e;

la Fig. 5 est une vue d'un dispositif de traitement de feuilles par jets de plasma sans anodes;

la Fig. 6 est un schéma pour illustrer le déplacement d'un jet de plasma dirigé contre la surface d'une feuille à traiter selon l'invention;

les Figures 7a à 7d sont des illustrations de feuilles traitées auxquelles l'on applique un test de mouillabilité;

la Fig. 7e est une illustration d'une feuille après traitement soumise à un test de la pureté après traitement;

la Fig. 8a est une photographie SEM (Scanning Electron Microscope) d'une feuille d'aluminium recuite par un traitement de plasma selon l'invention;

la Fig. 8b est une photographie SEM de la surface d'une feuille d'aluminium non traitée ;

La fig. 8c est une photographie SEM en coupe d'une pile de feuilles d'aluminium traité par un procédé de plasma selon l'invention ;

La fig. 9 est une vue en perspective simplifiée d'une forme d'exécution de l'invention comprenant un dispositif de génération de champ magnétique ;

La fig. 10a est une vue en perspective, simplifiée, d'une installation de traitement par plasma pour le traitement de fils, selon l'invention;

La fig. 10b est une vue en coupe, simplifiée, de installation de traitement par plasma pour le traitement de fils selon la figure 10a;

La fig. 11a illustre la disposition des générateurs de plasma pour le traitement d'une feuille métallique selon une variante où une partie des gaz de traitement est dirigée entre les jets de plasma et une autre partie est dirigée vers une partie avale des jets de plasma dans le zone de traitement de manière à comprimer le flux de plasma contre la surface à traiter et à en élargir la traînée ;

La fig. 11b est une vue partielle dans la direction XIb de la figure 11a ;

La figure 11c illustre la disposition des générateurs de plasma pour le traitement d'une feuille métallique selon une forme d'exécution de l'invention comprenant des générateurs de vibrations acoustiques, notamment ultrasoniques, externe ;

la Fig. 12a est une vue en coupe, simplifiée, d'une forme d'exécution d'une installation de traitement de feuille comprenant des dispositifs de traitement par plasma, un dispositif de stabilisation de courants d'air, et des paliers hydrodynamiques, selon l'invention;

la Fig. 12b est une vue partielle d'un palier de la forme d'exécution selon la figure 12a ;

la Fig. 13a est une vue en perspective, simplifiée, d'une forme d'exécution d'une installation de traitement d'objets à traiter à grandes surfaces, tels que des tôles de carrosseries automobiles, selon l'invention ;

la Fig. 13b illustre la disposition de générateurs de plasma de la forme d'exécution selon la figure 13a ; et

la Fig. 13c est une vue en coupe partielle d'un générateur de plasma de la forme d'exécution de la figure 13a.

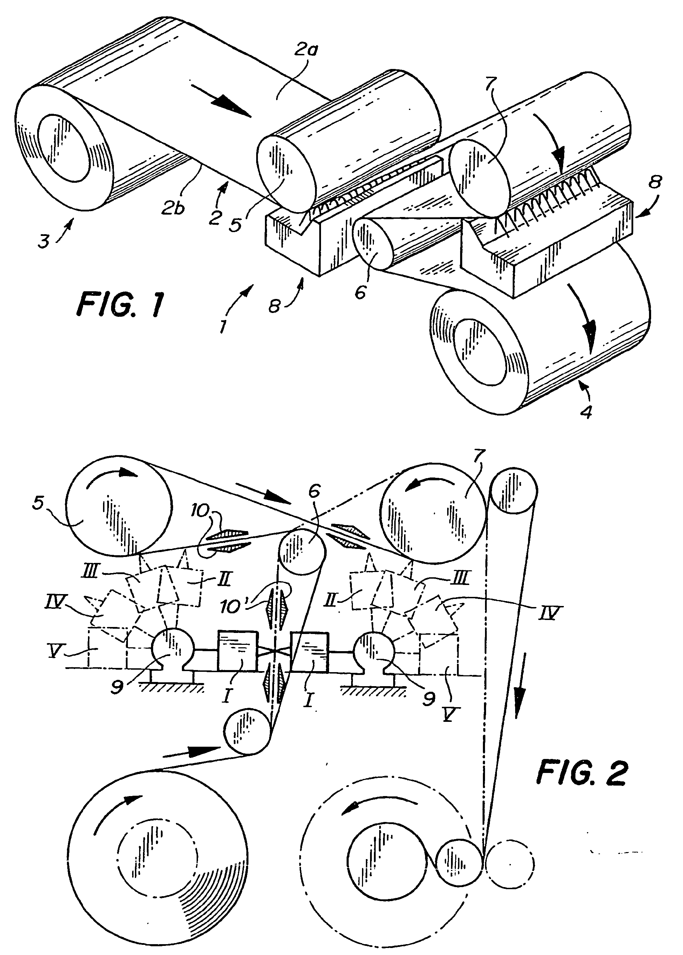

Les Fig. 1 et 2 montrent de manière simplifiée une partie d'une installation de traitement de feuilles, par exemple de feuilles d'aluminium, obtenues par laminage et présentée sous forme d'un rouleau 3 monté en rotation dans l'installation. La feuille 2 est tendue entre le rouleau donneur 3 et un rouleau accepteur 4 à travers un parcours de rouleaux de guidage 5,7 et rouleaux tendeurs 6 montés en rotation, certains sur ressorts pour exercer une force de tension bien précise sur la feuille d'aluminium. Certains rouleaux de guidage 5, 7 servent également à positionner la feuille d'aluminium par rapport à des dispositifs de traitement par jets de plasma 8, 9. Les installations montrées dans les Figures 1 et 2 comprennent au moins deux dispositifs de traitement par jets de plasma 8, 9 pour pouvoir traiter les deux faces 2a, 2b de la feuille 2. L'installation peut comprendre deux ou plusieurs séries de générateurs de plasma ou dispositifs de traitement disposées le long d'un côté de la feuille de manière consécutif, chaque dispositif comprenant au moins un générateur cathodique et au moins un générateur anodique.

Comme illustré dans la Fig. 2, les dispositifs de traitement par jets de plasma peuvent être montés sur un dispositif cinématique 9 qui permet par exemple la rotation du dispositif de traitement autour d'un axe essentiellement parallèle à l'axe des rouleaux, de façon à pouvoir faire prendre au dispositif de traitement par jets de plasma différentes positions par rapport à la feuille à traiter. La position I correspond à une position de traitement des faces opposées d'une feuille 2' (suivant le pointillé) où deux dispositifs de traitement 8a, 8b sont disposés de part et d'autre de la feuille. Les positions II et III correspondent à des angles différents pour le traitement d'une feuille 2 pour le traitement des faces opposées de cette feuille par des dispositifs de traitement par jets de plasma disposés à proximité de deux rouleaux de guidage 5, 7. La position IV est une position dégagée de la feuille à traiter pour permettre la mise en route de l'installation, notamment l'allumage des jets de plasma. La position V est une position dégagée permettant la maintenance et la réparation du dispositif de traitement par jets de plasma.

L'installation peut en outre comprendre des dispositifs de stabilisation de courants d'air 10 disposés en amont de la position de travail II, III des dispositifs de traitement par jets de plasma, à proximité de la surface de la feuille à traiter. De préférence, deux organes 10 sont disposés de part et d'autre de la feuille à traiter pour stabiliser le courant d'air entraîné par le déplacement de la feuille, notamment pour le rendre laminaire, de sorte que ce courant d'air ne dérange que le moins possible le courant des jets de plasma. D'autre part, les organes de stabilisation 10 réduisent les mouvements de la feuille dus à des turbulences pour éviter un éventuel chiffonnement de la feuille. Les organes de stabilisation 10 se présentent sous forme de déflecteurs dont la position peut être réglée par rapport à la feuille de manière à augmenter ou diminuer le flux d'air entraîné par la feuille. Ceci permet également de régler le traitement par le plasma en alimentant celui-ci par plus ou moins d'air. On peut également positionner d'autres organes de stabilisation 10' en aval des dispositifs de traitement par jets de plasma ou en d'autres positions le long de la feuille pour laminariser les flux d'air afin d'éviter le chiffonnement de la feuille.

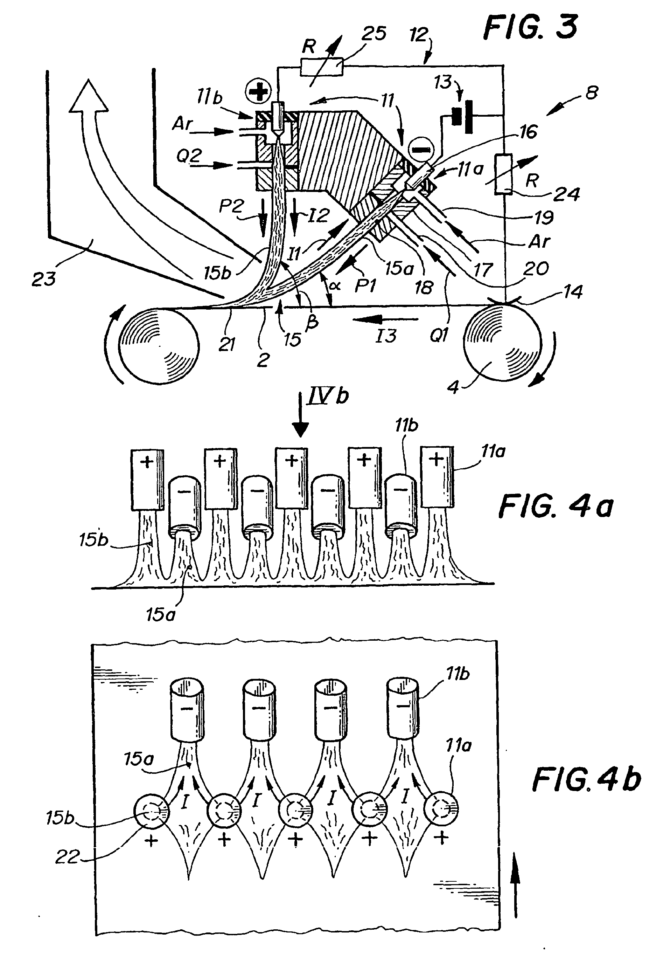

Faisant référence à la Fig. 3, le dispositif de traitement par jets de plasma 8 comprend des générateurs de jets de plasma 11 munis d'électrodes reliées à un circuit électrique 12 comprenant une source d'énergie électrique 13 pour la génération du plasma. Les générateurs 11 sont connectés électriquement à travers des résistances de ballast 24,25 à la feuille à traiter, par exemple par un contact 14 sur le rouleau de guidage 5, 7. La feuille à traiter 2 est conductrice et fait partie de la boucle du circuit électrique avec les jets de plasma 15. Le courant électrique, passant par l'objet à traiter peut être varié à l'aide de la résistance 24 et peut même être annulé.

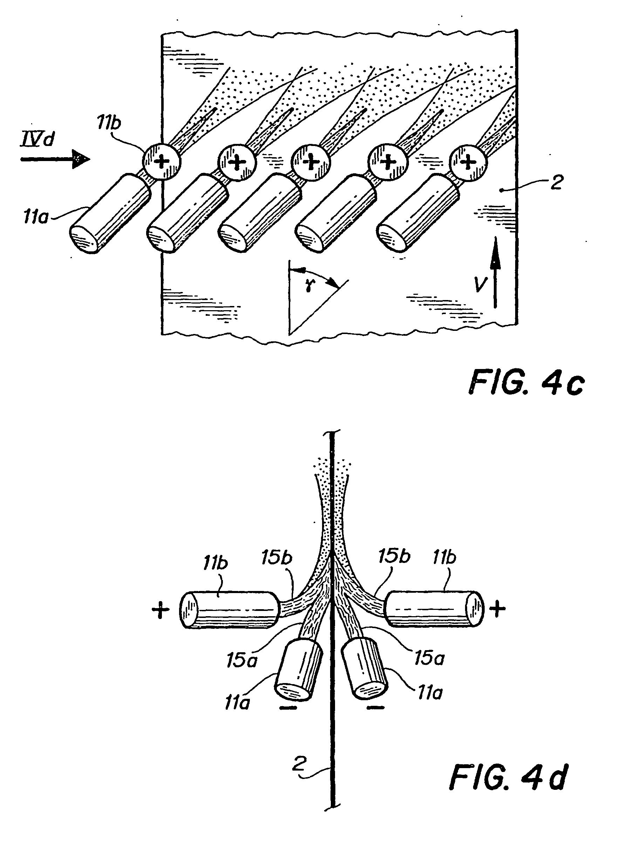

Dans cette forme d'exécution, il y a deux séries de générateurs de jets de plasma 11a, 11b de polarités opposées, c'est-à-dire une série de générateurs de jets de plasma anodiques 11b et une série de générateurs de jets de plasma cathodiques 11a. Les générateurs de jets de plasma de chacune des séries 11a, 11b sont disposés essentiellement en ligne de manière juxtaposée. Les générateurs de jets de plasma d'une série sont de préférence décalés de manière à avoir une position interposée par rapport aux générateurs de l'autre série, tel que montré dans les Figures 4a et 4b.

Chaque générateur de jet de plasma comprend une électrode 16 montée dans un corps 17 et un canal 18 formé dans le corps 17 pour canaliser le jet de plasma. Le canal est connecté à des canaux d'entrée 19, 20 de gaz de traitement. Dans cet exemple, deux canaux d'entrée de gaz et de traitement sont montrés, mais on peut également avoir d'autres canaux d'entrée de gaz de traitement débouchant dans le canal du jet de plasma 18. Un premier canal d'entrée 19 est situé approximativement au niveau de l'électrode, et un deuxième canal d'entrée 20 est situé en aval du premier.

Le corps 19 peut être muni d'un circuit de refroidissement parcouru par un liquide de refroidissement (non illustré) pour refroidir les générateurs de plasma.

Le gaz de traitement injecté dans le premier canal d'entrée 19 est de préférence un gaz inerte, tel que de l'argon (Ar) qui permet d'une part d'enrober et protéger les électrodes 16 d'oxydation, d'autre part, de faciliter la génération du plasma. Les autres canaux en aval 20 peuvent être utilisés pour injecter un flux de gaz d'apport, tel que de l'air, de l'argon, de l'oxygène, de l'azote, de l'hélium, de l'acide carbonique, du gaz naturel, des vapeurs organométalliques, ou un mélange de plusieurs de ces derniers, selon le traitement à effectuer sur la feuille 2. Le gaz d'apport de la première série de générateurs de jets de plasma 11a peut être différent des gaz d'apport injectés dans la deuxième série de générateurs de jets de plasma 11b.

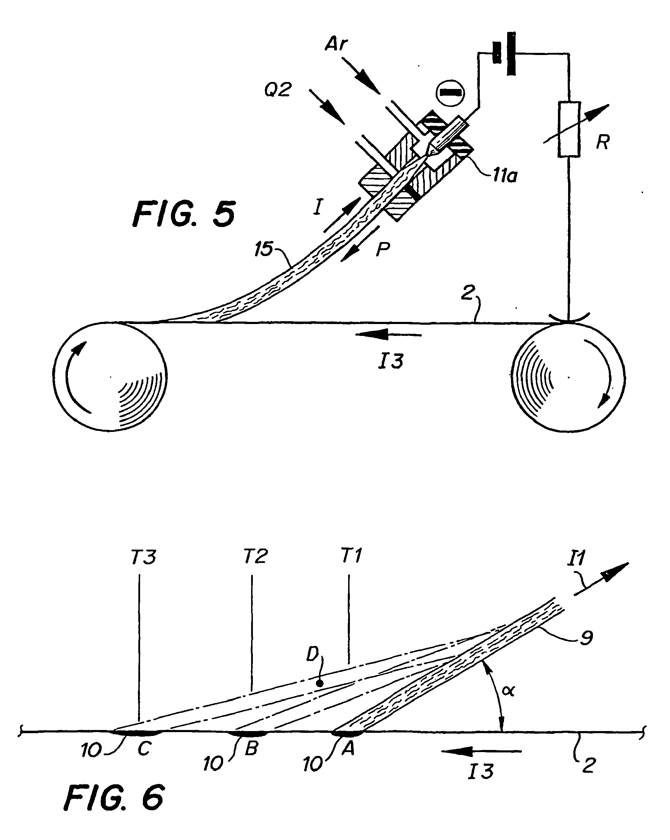

Une série de générateurs de plasma 11a est disposée de manière à produire des jets de plasma 15a dirigés approximativement dans une direction faisant un angle aigu $\alpha$ avec le plan ou la tangente d'une zone 21 de la feuille 2 en contact momentané avec le jet de plasma 15a, le jet étant avantageusement dirigé dans le sens contraire au déplacement de la feuille. Cette configuration des générateurs de jets de plasma selon l'invention, également montrée dans la forme d'exécution selon la Fig. 5, permet avantageusement d'améliorer l'uniformité du traitement de la feuille ou de la surface à traiter d'autres objets ayant de grandes surfaces, par exemple des plaques ou des cylindres.

Dans la forme d'exécution montrée dans la Fig. 3, une deuxième série d'électrodes 11b est disposée de manière à ce que l'angle $\beta$ formé entre le jet de plasma 15b sortant de ce générateur et le plan de la surface ou de la tangente à la surface dans la zone de contact 21 est plus grand que l'angle aigu $\alpha$ de la première série de jets 15a. L'angle $\beta$ de la deuxième série de jets par rapport à la surface à traiter est avantageusement proche de 90°. De préférence, les électrodes de la première série de générateurs sont des cathodes et les électrodes de la deuxième série de générateurs 11b sont des anodes. De manière avantageuse, les débits de gaz des générateurs sont choisis de telle manière que les impulsions des jets de plasma 15a de la première série de générateurs sont supérieures aux impulsions de jets de plasma 15b de la deuxième série de générateurs 11b.

Les jets de plasma anodiques 15b en contact avec la surface à traiter forment des taches anodiques 22 qui

**EP 1 332 650 B1**

libèrent des produits organiques qui recouvrent la surface à traiter, par suite de leur ablation et de leur oxydation plasmochimique. Ces réactions plasmochimiques forment des gaz résiduels, tels que le $CO_2$, qui peuvent être évacuées par une tubulure d'aspiration 23 disposée au-dessus de la zone de traitement momentané 21. Le passage du courant $I_3$ entre le jet de plasma cathodique 15a et la surface à traiter avec formation d'une tache anodique 22, intensifie le processus d'échauffement du matériau, et la destruction plasmochimique des produits se trouvant dans la couche limite. Les restes résiduels sont brûlés dans le jet de plasma anodique 15b, dont la composition des gaz de traitement et donc du plasma est choisie en fonction du type des résidus. En particulier, le gaz de traitement peut être de l'air ou de l'oxygène de façon à ce que le plasma est détruise les résidus organiques et les hydrocarbures en les oxydant.

On peut nettoyer la surface oxydée en ajoutant un gaz d'apport réduisant tel que le $H_2$, au jet de plasma cathodique 15a, utilisant le fait que celui-ci a un contact plus ferme avec la surface à traiter que le jet de plasma anodique 15b.

L'uniformité du traitement est assurée grâce à la disposition des générateurs de jets de plasma anodiques et cathodiques selon la présente invention.

Comme l'angle $\alpha$ entre la surface entre la feuille ou l'objet à traiter et le jet de plasma cathodique est aigu, les courants $I_1$ et $I_3$ circulant dans le plasma et la feuille, respectivement, ont des directions en sens inverse ce qui provoque leur répulsion. En conséquence, comme illustré dans la Fig. 6, les jets de plasma 15a, et donc les taches anodiques 22, se déplacent de la position A (moment $\tau_1$) aux positions B (moment $\tau_2$) et puis C (moment $\tau_3$). Ce processus se poursuit jusqu'au moment où la différence de potentiel devient plus grande que la tension de court-circuit entre les points A et D. Après le court-circuit, ce processus se répète. De cette manière, on a un mouvement continu de va-et-vient rapide de la tache anodique le long de la surface à traiter. La vitesse de ce mouvement dans le sens de déplacement de la surface à traiter (ci-après direction "longitudinale") est bien supérieure à la vitesse de déplacement de la surface à traiter. Cela assure l'uniformité longitudinale du traitement et l'absence d'endommagements dus à des échauffements locaux excessifs.

Une bonne uniformité de traitement dans une direction transversale à la direction longitudinale, c'est-à-dire le long du front de plasma, est obtenue en disposant les générateurs de plasma anodiques et cathodiques de manière alternée, tel que montré dans les figures 4a et 4b. Une telle disposition fait que chaque générateur de plasma est relié électriquement avec deux générateurs de pôles opposés. Le courant électrique s'écoule pratiquement uniformément le long de la surface à traiter, dans la direction transversale à son mouvement, ce qui assure l'uniformité du traitement.

Si le nettoyage de la surface n'est pas nécessaire, et qu'il n'est question que d'un traitement thermique, par exemple d'un recuit, d'une fusion des microfissures, ou d'un polissage superficiel, on utilise de préférence les générateurs de plasma cathodiques , tel que montré dans la Fig. 5.

Le traitement des deux faces de la feuille de matériau peut être effectué à l'aide d'au moins deux séries de générateurs de plasma disposés de chaque côté de la feuille, tel que montré dans la Fig. 1 ou la Fig. 2, et dans les figures 4d à 4f.

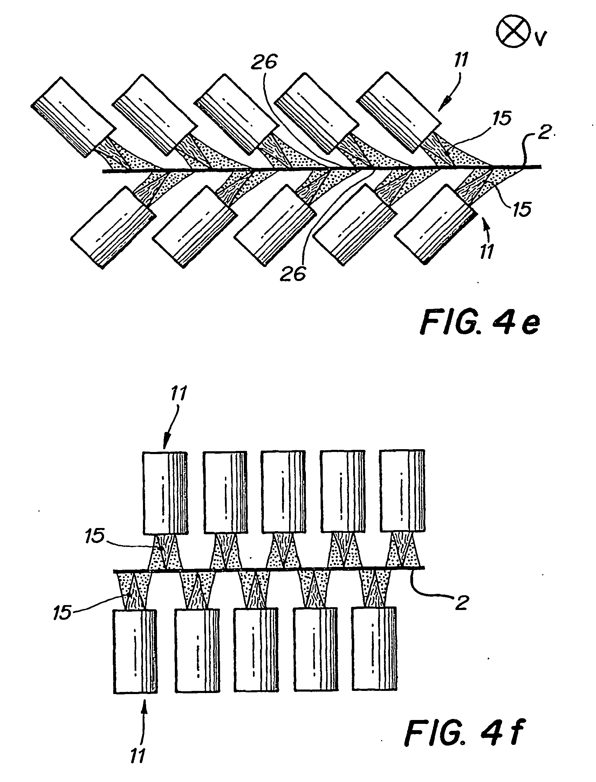

Les générateurs de plasma 11 de chaque côté de la feuille à traiter 2 peuvent être soit en regard les un des autres comme montré dans la figure 4f, soit décalés comme montré dans les figures 4e et 4f. Dans les variantes où les générateurs de plasma 11 sont décalés, les zones intermédiaires 26 entre deux générateurs du même côté de la feuille sont avantageusement échauffée par les jets de plasma 15 de l'autre côté de la feuille, et vice-versa, améliorant ainsi le traitement.

Dans la variante des figures 4c et 4d, les axes des générateurs cathodiques sont inclinés d'un angle $\gamma$ par rapport à la direction de déplacement v de la feuille à traiter de manière à augmenter la surface d'application des jets de plasma contre la surface à traiter, c'est-à-dire d'augmenter la zone de traitement, ce qui améliore l'uniformité du traitement. L'angle $\gamma$, en pratique peut varier de 30° à 60° mais est avantageusement de 45°.

Le dépôt de films peut être effectué en ajoutant des gaz ou des vapeurs de produits réactifs, par exemple un mélange gazeux contenant des vapeurs organométalliques, au gaz d'apport Q1, $Q_2$ ou directement dans la zone de contact 21 du plasma avec la surface à traiter.

L'invention permet également d'effectuer d'autres opérations, telles que le polissage, l'élimination de fissures superficielles, et le décapage des feuilles conductrices d'électricité.

Suivant les paramètres de la feuille conductrice à traiter tels que sa vitesse et son épaisseur, et suivant les exigences du traitement (par exemple, nettoyage ou dégraissage sans recuit, dégraissage avec recuit, recuit de différente intensité), le traitement peut s'effectuer sur les deux faces de la feuille simultanément, ou consécutivement ou encore sur chacune des faces, lors de leur contact avec un support refroidi, par exemple un rouleau métallique. Ces réalisations sont illustrées dans la Fig. 2, qui montre un exemple de dispositif permettant les différents traitements précités grâce au mécanisme de rotation qui permet de fixer le dispositif de traitement par jets de plasma dans différentes positions (I, II, III) par rapport à la feuille métallique à traiter. Ce mécanisme prévoit également des positions IV et V, respectivement pour la mise en route du générateur de plasma et pour les travaux d'entretien et de réparations éventuelles. Suivant les différents modes de traitement, différents systèmes d'enroulement sont prévus.

Faisant référence à la figure 11a, une meilleure efficacité du traitement peut être obtenue lorsque les gaz d'apport Q sont alimentés par des conduits 27 suivant une direction proche de la bissectrice de l'angle formé par les jets cathodique 15a et anodique 15b.

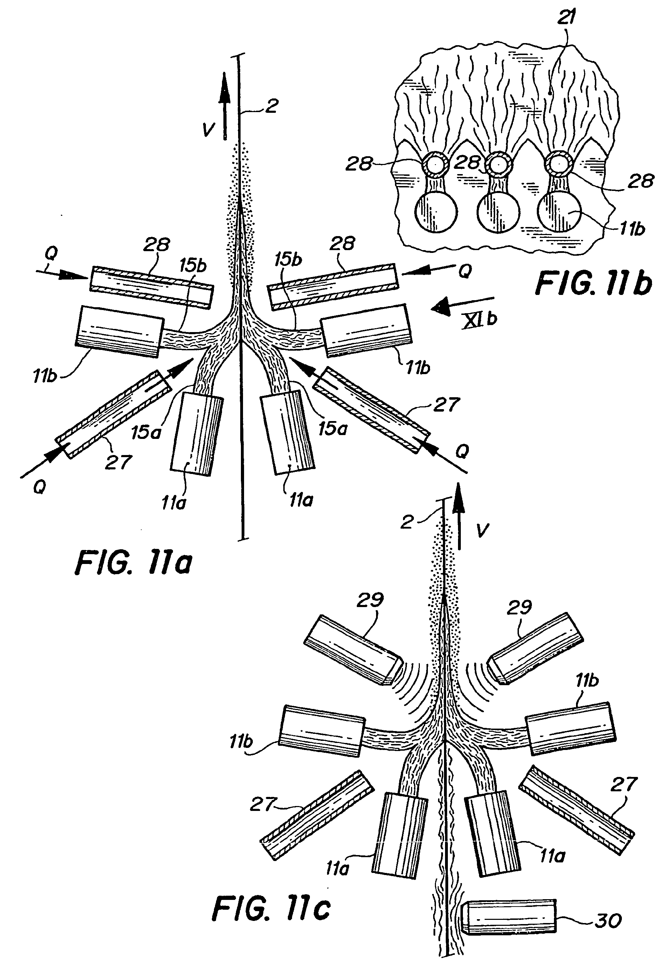

Pour obtenir une bonne uniformité du traitement, il est avantageux d'introduire des gaz d'apport directement en aval de l'impact des jets de plasma 15a, 15b sur la feuille à traiter, par des conduits 28. Les gaz projetés sur la feuille à traiter l'enrichissent en particules réactives, et d'autre part forcent le plasma de s'étaler de manière à recouvrir une zone de traitement 21 plus large que les zones directement aspergées par les jets de plasma, comme illustré dans les figures 11a et 11b.

Dans une autre forme d'exécution de la présente invention, telle que montré dans la figure 11c, visant une plus grande efficacité de l'interaction entre le plasma et la surface à traiter, celle-ci est vibrée par un ou plusieurs générateur de vibrations acoustiques 29, 30 disposés en amont et/ou en aval de la zone de traitement. Les fréquences sont avantageusement dans le domaine des ultrasons. Les vibrations ont l'effet d'augmenter l'interaction entre la surface à traiter et le plasma, de manière similaire à une augmentation de température, en raison de l'augmentation de l'énergie cinétique des atomes de la surface à traiter. D'autre part, les vibrations de la surface à traiter améliorent les réactions plasmochimiques entre les gaz d'apport du plasma et la surface à traiter en améliorant l'évacuation et l'échange des gaz se trouvant sur la surface à traiter.

Les vibrations acoustiques peuvent aussi être générées par le plasma lui-même, en alimentant les arcs de plasma en courant pulsé, soit unipolaire, soit alternatif. La durée du front des impulsions est choisie de manière que le plasma se développe d'abord de manière isochorique pour qu'il émette à chaque impulsion une onde de choc qui transmette son énergie cinétique à la surface à traiter sous forme de vibrations. Avantageusement, la fréquence de répétition des impulsions de courant électrique formant le plasma est choisie de façon à ce qu'elle corresponde à la fréquence de vibration de la surface à traiter. Lorsque ces impulsions génèrent des vibrations acoustiques, les auteurs de la présente invention ont trouvé que le plasma "chante". L'apparition de ce "chant" est automatiquement accompagnée d'une augmentation sensible de l'efficacité du traitement. L'intensité et la fréquence des oscillations de la surface traitée sont contrôlées dans la présente invention à l'aide d'un détecteur de vibrations acoustiques ou ultrasoniques.

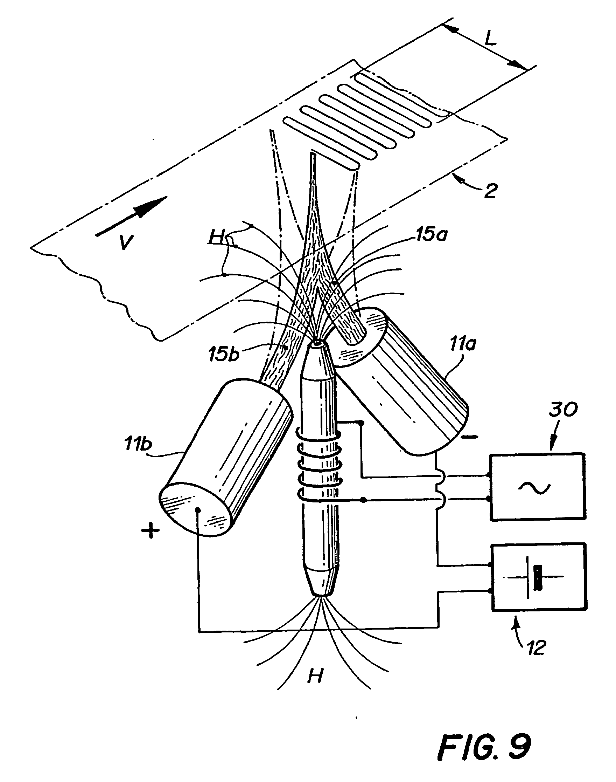

Dans une autre forme d'exécution de la présente invention, illustré dans la figure 9, les jets de plasma sont soumis à l'action d'un champ magnétique H alternatif généré par un générateur de champ magnétique 30, dont les lignes de force sont dirigées perpendiculairement aux lignes de courant des jets cathodique 15a et anodique 15b. Il en résulte une oscillation du jet de plasma appliqué contre la surface à traiter, due à l'action des forces d'Ampère, et donc un balayage de cette surface par le jet de plasma sur une plage de largeur L, déterminée par la grandeur du courant électrique et l'amplitude du champ magnétique. La fréquence $\nu$ d'oscillation du champ magnétique est choisie de telle manière que le plasma recouvre entièrement la plage d'oscillations c.à.d que :

$$\nu \leq v/d$$

où d est le diamètre de la projection du jet de plasma sur la surface traitée et v est la vitesse de déplacement de la surface à traiter par rapport au générateurs de plasma 11a, 11b.

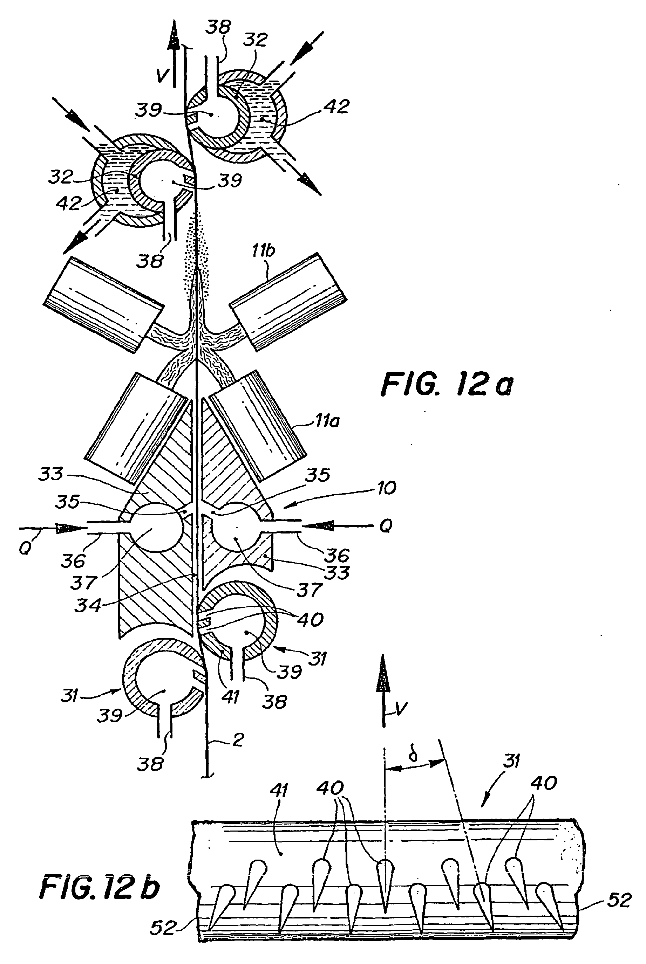

La figure 12a montre une forme d'exécution avantageuse pour le traitement de longues feuilles minces, telles que des feuilles d'aluminium, comprenant des générateurs de plasma 11a,11b, des paliers hydrodynamiques 31, 32 et un dispositif de stabilisation de courants d'air 10. L'ensemble montré dans la figure 12a peut faire partie d'une installation de traitement, par exemple dans une installation telle que montré dans la figure 2.

Le dispositif de stabilisation 10, disposé à proximité des générateurs de plasma 11a, 11b, permet non seulement de laminariser le flux d'air à la surface de la feuille pour éviter son chiffonnement, mais également de régler et de contrôler la quantité et la composition du mélange gazeux dans la zone de traitement. Il comprend deux corps 33 formant un interstice 34 étroit pour le passage de la feuille. Les mélanges de gaz d'apport Q réactifs sont introduits dans l'interstice par des orifices 35 dans chaque corps 33, connectés à une entrée 36 via un collecteur 37 qui permettent d'assurer une bonne distribution du gaz d'apport aux orifices.

Les paliers aérodynamiques 31, 32 disposés en amont et en aval du dispositif de stabilisation et des générateurs de plasma, de chaque côté de la feuille en léger chevauchement, permettent de tendre, stabiliser et positionner la feuille à traiter par rapport aux dispositif de stabilisation 10 et générateurs de plasma. Les paliers aérodynamiques ont l'avantage d'accomplir les fonctions précitées sans augmentation significative des forces de frottement. Chaque palier comprend une entrée d'air 38 sous pression connectée via un collecteur 39 à des orifices de sortie 40, dirigés à contre courant du déplacement de la feuille, pour créer un coussin d'air entre la feuille et le corps du palier 41. Les orifices de sortie 39 ont de préférence une forme longitudinale et sont distribuées sur la largeur de la feuille. L'angle $\delta$ que la direction longitudinale des orifices forme avec la direction de déplacement v de la feuille est proche de 0° au centre de la feuille et augmente vers les bords latéraux 52 comme montré dans la figure 12b, éventuellement jusqu'à 90°.

Les paliers 32 en aval peuvent être refroidis par un circuit d'eau, de manière à refroidir les paliers ainsi que la feuille en aval de la zone de traitement.

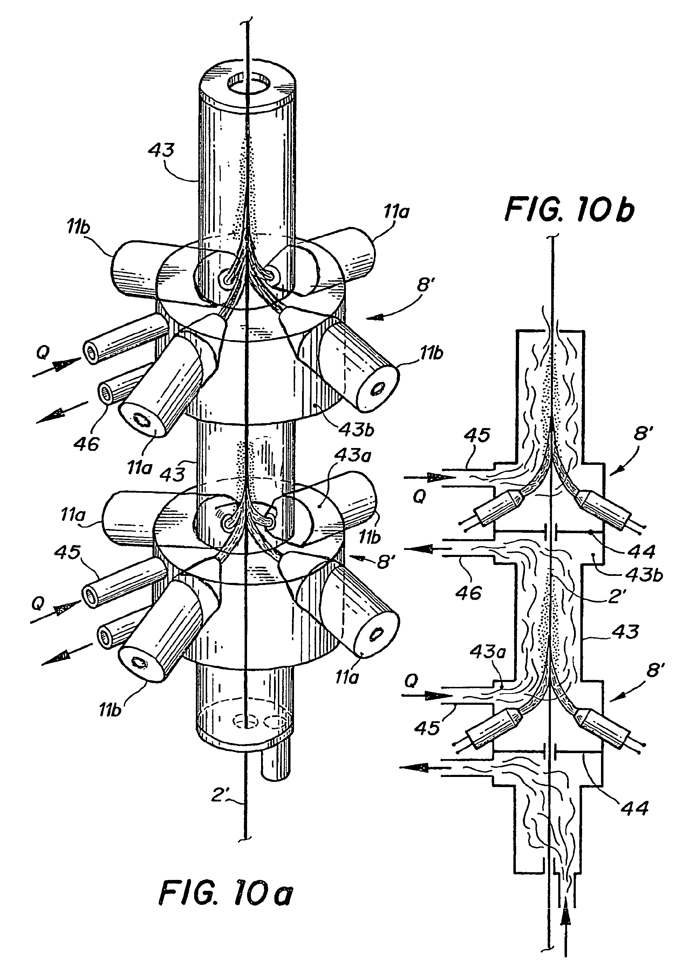

Faisant référence aux figures 10a et 10b, une forme d'exécution pour le traitement (nettoyage, décapage, recuit, formation d'alliage superficiel, dépôt de film) de fils est montrée. L'installation de traitement comprend des générateurs de jets de plasma 11 disposés autour du fil à traiter 2'. Les générateurs sont de préférence disposés symétriquement autour du fil au nombre de quatre jets de plasma ou plus. De préférence, les jets cathodiques 11a et les jets anodiques 11b sont disposés de façon alternées. Il est toutefois possible d'avoir d'autres configurations et même un nombre de jets cathodiques différent du nombre de jets anodiques sans sortir du cadre de l'invention.

Le dispositif peut comprendre deux ou plusieurs séries 8' de générateurs de plasma 11 disposées le long du fil, chaque série 8' comprenant au moins un générateur cathodique et au moins un générateur anodique. Chaque série peut être séparé du prochain par un réacteur 43 tubulaire, par exemple de forme cylindrique, isolant le fil de l'atmosphère ambiante, et dont la longueur est environ égale à la distance sur laquelle le plasma reste actif. Le réacteur tubulaire est muni d'un collecteur d'entrée 43a et de sortie 43b des gaz d'apport réactifs, ainsi que de filières 44 d'entrée et de sortie pour le guidage du fil lors de son passage à travers le dispositif. Le fil, lors de son passage à travers le dispositif est stabilisé et centré par les filières 43. On peut avantageusement, par l'intermédiaire des filières, communiquer au fil des oscillations acoustiques ou ultrasoniques. Les gaz d'apport réactifs Q sont introduits dans le dispositif par des conduits d'entrée 45 et sont évacués par des conduits de sortie 46.

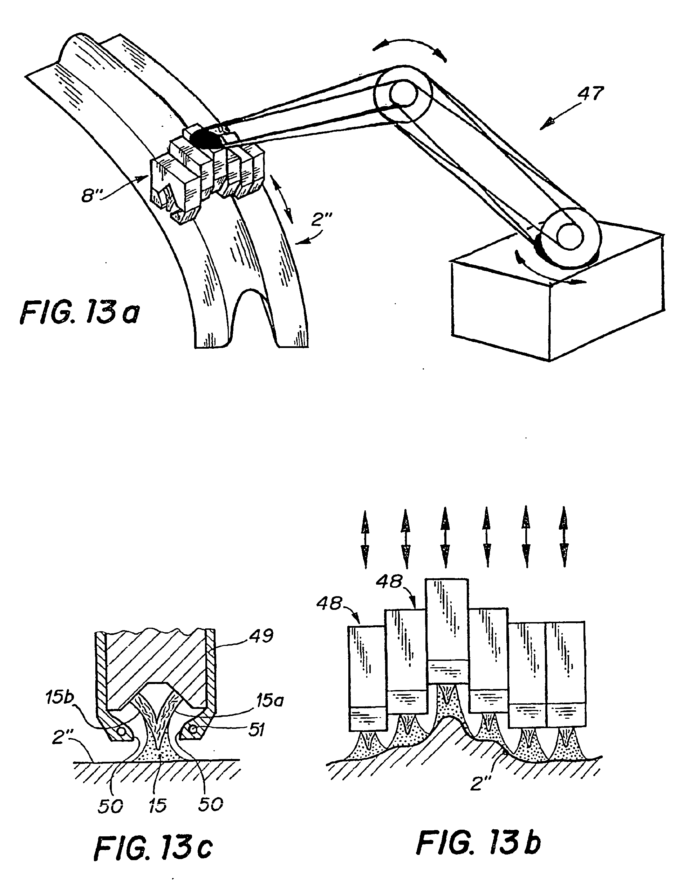

Faisant référence aux figures 13a à 13b, une installation de traitement pour des objets à traiter 2" à surfaces complexes, tels que des tôles de carrosseries d'automobiles, comprend un dispositif de traitement 8" monté sur un dispositif de déplacement 47, tel qu'un robot industriel. Le dispositif de traitement comprend une série de blocs 48 de générateurs de plasma 11a, 11b amovible les uns par rapport aux autres de façon à permettre aux blocs d'épouser la surface complexe. Chaque bloc peut être équipé d'un capteur (non illustré) pour contrôler la distance entre le bloc et la surface et pour commander un moteur (non illustré) pour déplacer le bloc.

Chaque bloc comprend au moins un générateur de jet cathodique et au moins un générateur de jet anodique. Chaque bloc peut en outre comprendre un boîtier ayant une partie d'embouchure 50 munie d'un circuit de refroidissement 51, dont la rôle est de stabiliser le jet de plasma et de l'envelopper d'un courant stabilisant de gaz, comprimant le plasma 15 contre la surface à traiter.

Ci-après sont donnés des exemples non-limitatifs de mise en oeuvre du procédé selon la présente invention.

<u>Exemple 1</u> :

<u>Nettoyage d'une feuille d'aluminium des résidus de graisse de laminage.</u>

Deux dispositifs de traitement par jets de plasma identiques comprenant chacun 10 couples de jets de plasma anodiques et cathodiques, sont disposés de part et d'autre de la feuille à traiter afin de traiter les deux faces de la feuille. Deux configurations ont été testées: celle où les deux dispositifs sont disposés au même endroit de la feuille et effectuent le traitement des deux faces simultanément, tel qu'illustré par la position 1 de la Fig. 2, et celle où les deux dispositifs sont disposés à des endroits différents de la feuille et effectuent le traitement des deux faces consécutivement, tel qu'illustré par les positions II ou III de la Fig. 2. Les deux configurations diffèrent en ce que la température de la feuille à traiter dans la zone de traitement pour la configuration I est plus élevée, ne bénéficiant pas du refroidissement par les rouleaux et le traitement consécutif de la configuration II, III. La feuille traitée était une feuille d'aluminium de 100 $\mu$m d'épaisseur, et de 20cm de largeur, après laminage.

Les paramètres du traitement étaient les suivants :

| | |
|---|---|
| Courant cathodique ($I_1$) | : 15 A |
| Courant anodique ($I_2$) | : 10 A |
| Courant passant dans le matériau traité ($I_3$) | : 5 A |
| Angle entre l'axe du jet anodique et la feuille à traiter | : 90° |
| Angle entre l'axe du jet cathodique et la feuille à traiter | : 35° |
| Débit du gaz de protection (Ar) | : 0,5 l/min (pour chaque jet) |
| Débit de gaz d'apport | |
| Jet anodique (oxygène) | : $Q_1$ = 0,5 l/min |
| Jet cathodique (air) | : $Q_2$ = 2 l/min |
| Vitesse de déplacement de la feuille | : 3 m/sec |

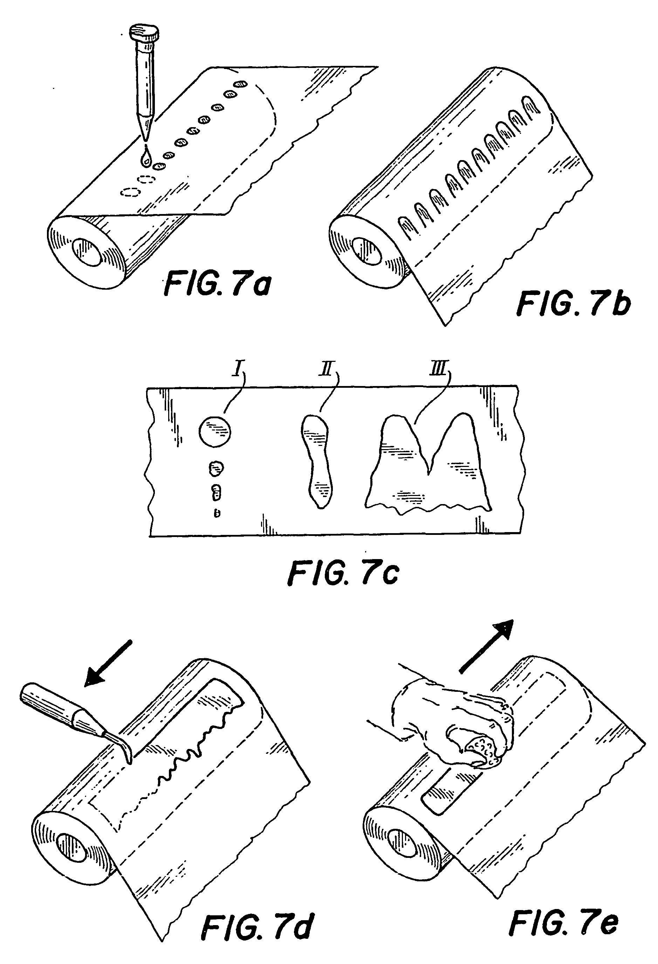

Les résultats du traitement ont été contrôlés par des tests considérés comme standard suivant la norme européenne EN 546-4, tel qu'illustré par les figures 7a à 7e. Le résultat du traitement a obtenu la note A+, signifiant qu'il est supérieur aux meilleurs résultats obtenus par les méthodes de nettoyage classiques.

En particulier la mouillabilité de la feuille a été vérifiée en déposant une série de gouttes d'eau distillée sur la surface traitée, en position horizontale tel qu'illustré par la Fig. 7a et en inclinant par la suite cette surface, tel qu'illustré par la Fig. 7b.

L'uniformité a aussi été vérifiée en déposant une coulée continue d'eau sur la surface traitée et en inclinant celle-ci, tel qu'illustré par la Fig. 7d.

Ces deux vérifications ont permis de démontrer une excellente uniformité du traitement.

L'analyse du carbone résiduel, effectué par la méthode Strölhein, a donné un résultat plus faible que $< 0,1 \mathrm{g/m}^2$ de carbone résiduel.

La surface à traiter a aussi été contrôlée vis-à-vis des résidus éventuels en phase solide, tels que des poudres d'oxydes ou autres résidus solides à l'aide d'un test de frottis d'ouate hygroscopique, tel qu'illustré par la Fig. 7e. L'ouate utilisée est restée propre, ce qui signifie l'absence de résidus.

Les analyses par microscope électronique (SEM) ont confirmé la pureté de la surface traitée, à une échelle inférieure à 1000 Å/cm.

Exemple 2 :

Recuit d'une feuille métallique d'aluminium.

Objet du recuit : feuille d'aluminium d'une épaisseur de 100 $\mu$m.

| | |
|---|---|
| Dispositif | : le courant dans la feuille est égal à zéro |
| Courant | : 20 A. |
| Tension | : 50 V |
| Angle entre le jet de plasma et la surface traitée | : $\alpha = 30°$ |
| Angle d'inclinaison des jets de plasma | $\gamma = 45°$ |

Un recuit total est observé pour une vitesse de déplacement de la feuille de 0,6m/sec.

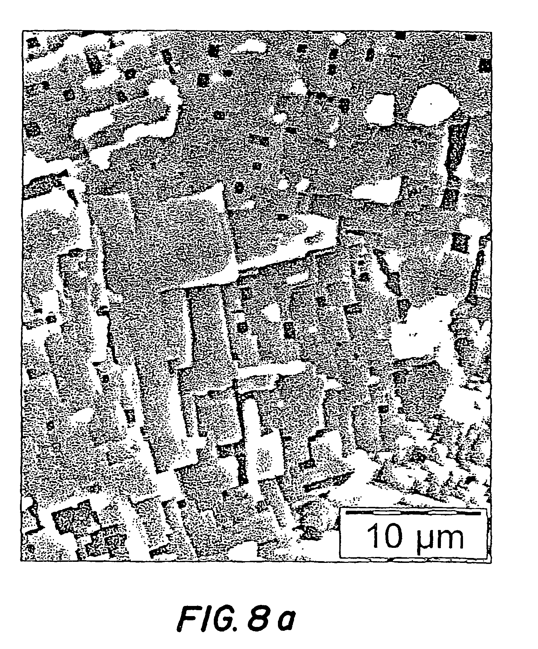

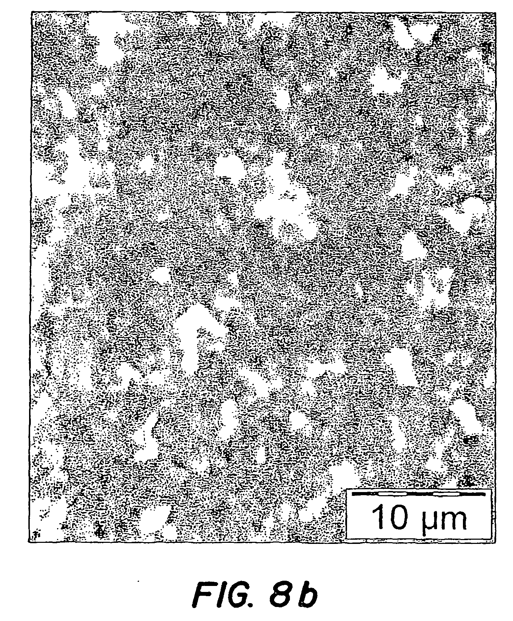

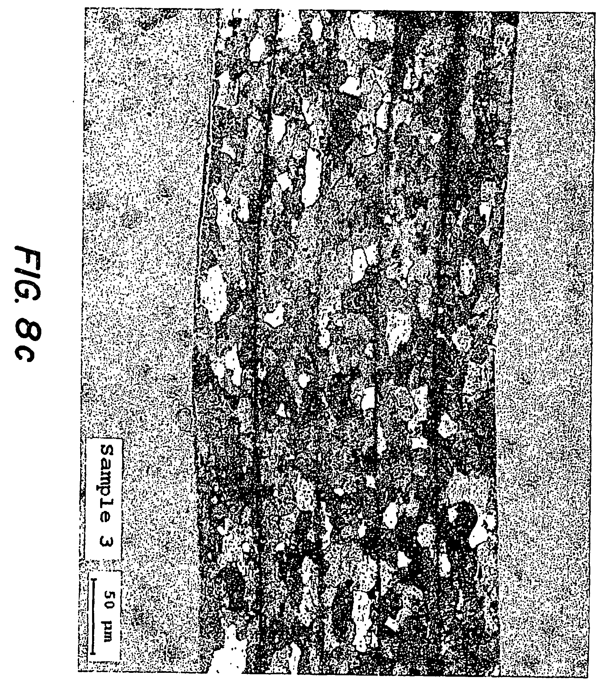

La structure superficielle du métal avant et après traitement, observée par SEM, est montrée sur les photographies SEM des Figures 8b /avant) respectivement 8a (après). La Fig. 8a montre une granulation caractéristique du recuit.

La figure 8c montre la structure, homogène, également granulée, sur toute l'épaisseur de la section de la feuille traitée.

Les valeurs mesurées de "l'éclatement" (combinaison de la tension de rupture et de l'allongement) sont de $300 \pm 20$ kPa. Cette valeur correspond aux meilleures valeurs des étalons de feuilles d'aluminium recuites suivant les méthodes classiques. Il a été constaté que l'éclatement est uniforme ($\pm$ 10%) sur toute la largeur des échantillons des feuilles traitées.

Exemple 3 :

Stérilisation d'une feuille d'acier.

Les propriétés de stérilisation suivant un procédé selon l'invention ont été vérifiées en contaminant, avant le traitement, la feuille d'acier par quatre sortes de micro-organismes. Les températures nécessaires pour leur destruction par effet thermique simple (par exemple par pasteurisation) sont données dans le tableau 1.

Tableau 1 :

| Tableau 1 : N° | Micro-organismes | Symbole | Température de destruction thermique pour une exposition de 1 minute |
|---|---|---|---|
| 1 | Aspergillus niger | A. n | 68°C |
| 2 | Saccharomyces cerevisiae | S.c | 78°C |
| 3 | Byssochlamys fulva | B.f | 98°C |
| 4 | Bacillus subtilis | B.s | 140°C |

Des gouttes d'eau contenant $10^9$ micro-organismes par ml étaient déposées et séchées sur la feuille avant son traitement. Le traitement de la feuille contaminée était exécuté à une vitesse de balayage constante.

Les régimes utilisés sont les suivants (tableau 2) :

Tableau 2 :

| N° du régime | Courant (A) | | | Gaz (débit l/min) | | Tableau 2 | |
|---|---|---|---|---|---|---|---|
| | Cathode | Anode | Feuille | Cathode | Anode | Vitesse de balayage m/sec | Temps d'exposition au plasma (sec) |
| I | 15 | 10 | 5 | Ar (0,5) | Ar (0,5) | 2 | 0,01 |
| II | 20 | 10 | 10 | Ar (1) | Ar (1) | 1 | 0,01 |
| III | 25 | 15 | 10 | Ar (0,5) Air (2) | Ar (0,5) Air (2) | 1 | 0,01 |
| IV | 25 | 15 | 10 | Ar (0,5) $O_2$ (0,5) | Ar (0,5) $O_2$ (0,5) | 0,5 | 0,02 |

Les résultats du traitement sont donnés au tableau 3 :

Tableau 3 :

| | | | Régimes de m.o survivants après traitement | | | |
|---|---|---|---|---|---|---|
| N° | Micro-organismes | Nombre avant traitement | I | II | III | IV*) |
| 1 | A.n | $3,7.10^7$ | $< 10^0$ | $< 10^0$ | $< 10^0$ | $< 10^0$ |
| 2 | S.c | $5,4.10^7$ | $< 10^0$ | $< 10^0$ | $< 10^0$ | $< 10^0$ |
| 3 | B.f | $2,9.10^7$ | $3,8.10^5$ | $< 10^0$ | $< 10^0$ | $< 10^0$ |
| 4 | B.s | $3,9.10^7$ | $9,1.10^6$ | $4,9.10^4$ | $< 10^0$ | $< 10^0$ |
| *) Tous les résultats obtenus pour le régime IV témoignent d'une légère altération du matériau, signifiant que le temps d'exposition est trop élevé. | | | | | | |

Comme le montre le tableau 3, une stérilisation complète, sans détérioration du matériau, est obtenue en régime 3, pour un temps d'exposition de 0,01 sec, soit de plus de 3 ordres de grandeur inférieur au temps de traitement thermique simple.

Exemple 4:

Dépôt de film de $SiO_2$ sur feuille d'Al.

La même installation que dans l'exemple 1 a été utilisée. La surface à traiter était une face d'une feuille d'aluminium de 30$\mu$m d'épaisseur, après laminage et nettoyage (activation) par plasma selon la présente invention.

Trois cas de traitement sont comparés :

a ) Les paramètres du traitement étaient par courant continu les suivants :

| | |
|---|---|
| courant cathodique ($I_1$) | : 20 A |
| courant anodique ($I_2$) | : 12 A |
| courant passant dans la feuille à traiter ($I_3$) | : 6 A |
| angle entre l'axe de jet anodique et la feuille à traiter | : $\alpha = 90°$ |
| angle entre l'axe de jet cathodique et la feuille à traiter | : $\beta = 30°$ |
| angle d'inclinaison des jets de plasma | : $\gamma = 45°$ |
| Débit de gaz de protection (Ar) | : 0,5 l/min |
| Débit de gaz d'apport | |
| Jet anodique (Ar + hexaméthyldisilasane + $O_2$) | : $Q_1 = 0,6$ l/min |

Suite de tableau

| Jet cathodique (Ar + O$_2$) | : Q$_2$ = 2 l/min |
| Vitesse de déplacement de la feuille | : 0,8 m/sec |

L'analyse ellipsométrique montre que le traitement a permis le dépôt peu uniforme ($\pm$ 20%) d'un film diélectrique de SiO$_2$ d'une épaisseur moyenne de 100 nm. Le degré d'adhésion est peu satisfaisant. La solidité diélectrique du film est de 0,2.10$^6$ V/cm. La couche de SiO$_2$ s'écaille sous l'action d'une vibration ultrasonique après le traitement par plasma à une fréquence de 45kHz, puissance de 300W, sur un échantillon carré de feuille traitée 10cmX10cm plongé dans l'eau

b ) Les paramètres du traitement par courant continu sont identiques au cas a). Un champ magnétique alternatif de fréquence 800Hz et d'amplitude 1,5.10$^{-4}$ T appliqué selon la figure 13 donne une augmentation sensible de l'uniformité du traitement ($\pm$ 5%). Les autres résultats sont pratiquement identiques au cas a).

c ) Les paramètres du traitement par courant en impulsions unipolaires étaient les suivants :

| amplitude du courant cathodique (I$_1$) | | : 20A |
| amplitude du courant anodique (I$_2$) | | : 12A |
| amplitude du courant dans le matériau traité | | : 8A |
| angles respectifs | $\alpha$ = 30° | |
| | $\beta$=90° | |
| | $\gamma$=45° | |
| fréquence des impulsions unipolaires de courant | | : 25kHz |
| durée du front de croissance des impulsions de courant | | : 2$\mu$sec |
| durée d'une impulsion | | : 20$\mu$sec |
| débits de gaz et vitesse de déplacement de la feuille | | : voir a) |

L'analyse éllipsométrique montre que le traitement a permis le dépôt uniforme ($\pm$ 5%) d'un film diélectrique de Si O$_2$ d'une épaisseur moyenne de 180nm. Le degré d'adhésion est satisfaisant. La couche de Si O$_2$ ne montre pas d'écaillement ou de crevasses après avoir soumis un échantillon carré de la feuille traitée (10cmX10cm), sous l'eau, pendant 20min, à l'action d'une vibration ultrasonique de fréquence 45kHz et de puissance 300W. La solidité diélectrique atteinte est de 0.3.10$^7$ V/cm.

**Revendications**

1. Procédé de traitement par plasma atmosphérique d'un objet à traiter (2) en un matériau conducteur d'électricité, comprenant la génération de jets de plasma (15) par des générateurs de plasma (11), l'application des jets de plasma sur une surface à traiter de l'objet à traiter, et le déplacement relatif de l'objet à traiter par rapport au générateurs de plasma, **caractérisé en ce que** au moins un des jets de plasma est un jet cathodique (15a) et au moins un des.jets de plasma est un jet anodique (15b), ledit jet anodique étant appliqué dans une zone de traitement sur ladite surface à traiter à proximité dudit jet cathodique, le courant électrique pour la génération des jets cathodique et anodique de plasma étant divisé en trois parties, l'une I$_3$ passant par l'objet à traiter et les deux autres I$_1$, I$_2$ servant à alimenter les jets anodique et cathodique de plasma.

2. Procédé selon la revendication 1, **caractérisé en ce que** le jet cathodique forme avec la surface à traiter un angle $\alpha$ aigu.

3. Procédé selon la revendication 1 ou 2, **caractérisé en ce que** le jet anodique forme avec la surface à traiter un angle $\beta$ qui est plus grand qu'un angle $\alpha$ formé entre le jet cathodique et la surface à traiter.

4. Procédé selon la revendication 3, **caractérisé en ce que** l'angle $\beta$ entre le jet anodique et la surface à traiter approche, ou est essentiellement égal à 90°.

5. Procédé selon la revendication 2, 3 ou 4, **caractérisé en ce que** l'angle $\alpha$ formé entre le jet cathodique et la surface à traiter est entre 25° et 60°.

**6.** Procédé selon l'une des revendications précédentes, **caractérisé en ce qu'**il comprend la génération d'une série de jets anodiques et jets cathodiques disposés de manière alternées dans une direction transversale à la direction de déplacement relatif de l'objet à traiter par rapport aux générateurs de plasma.

**7.** Procédé selon l'une des revendications précédentes, **caractérisé en ce que** l'impulsion des jets cathodiques a une puissance supérieure à celle des jets anodiques.

**8.** Procédé selon l'une des revendications précédentes, **caractérisé en ce qu'**un flux d'air ou de gaz entraîné par l'objet à traiter est séparé de la surface à traiter en amont de la zone de traitement.

**9.** Procédé selon l'une des revendications précédentes, **caractérisé en ce qu'**un flux de gaz entraîné par l'objet à traiter est laminarisé, en aval de la zone de traitement.

**10.** Procédé selon l'une des revendications précédentes, **caractérisé en ce que** les jets de plasma sont inclinés d'un angle aigu γ par rapport à la direction du déplacement relatif v de l'objet à traiter par rapport aux générateurs de plasma.

**11.** Procédé selon l'une des revendications précédentes, **caractérisé en ce que** l'objet à traiter est sous forme d'une feuille.

**12.** Procédé selon la revendication précédente, **caractérisé en ce que** des jets de plasma sont disposés de part et d'autre de la feuille.

**13.** Procédé selon la revendication précédente, **caractérisé en ce que** les jets de plasma sur un des côtés de la feuille sont disposés de manières décalés par rapport aux jets de plasma sur l'autre côté de la feuille.

**14.** Procédé selon l'une des revendications précédentes, **caractérisé en ce que** l'objet à traiter est sous forme d'un fil (2').

**15.** Procédé selon l'une des revendications précédentes, **caractérisé en ce que** un ou plusieurs jets de gaz d'apport Q sont dirigés sur les jets de plasma de manière à élargir et à comprimer les jets de plasma contre l'objet à traiter.

**16.** Procédé selon l'une des revendications précédentes, **caractérisé en ce que** l'on génère une vibration acoustique ou ultrasonique sur l'objet à traiter pendant l'action du plasma.

**17.** Procédé selon la revendication précédente, **caractérisé en ce que** la vibration acoustique ou ultrasonique est créée par un processus de génération du plasma en impulsions d'alimentation électrique où la durée du front de croissance de l'amplitude du courant des impulsions d'alimentation électrique est assez courte pour que le processus de croissance de l'amplitude de courant soit isochorique.

**18.** Procédé selon la revendication précédente, **caractérisé en ce que** la fréquence des impulsions d'alimentation électrique est proche ou égale à la fréquence des vibrations acoustiques.

**19.** Procédé selon l'une des revendications précédentes, **caractérisé en ce que** l'on génère un champ magnétique alternatif de manière que les forces d'Ampère résultantes provoquent une oscillation balayante des jets de plasma.

**20.** Procédé selon la revendication précédente, **caractérisé en ce que** la fréquence v d'oscillations du champ magnétique est égale ou supérieure au rapport de la vitesse relative de déplacement de l'objet à traiter au diamètre des jets de plasma.

**21.** Dispositif pour la mise en oeuvre du procédé selon l'une des revendications précédentes comportant au moins un générateur de jet de plasma cathodique (11a) et au moins un générateur de jet de plasma anodique (11b) disposés de manière à ce que le jet anodique est appliqué dans une zone de traitement sur la surface à traiter à proximité du jet cathodique, et un circuit électrique (12) pour l'alimentation des jets de plasma, un boucle du circuit électrique étant fermé par une partie de l'objet à traiter et comprenant un moyen pour varier le courant électrique $I_3$ circulant dans l'objet à traiter.

**22.** Dispositif selon la revendication 21, **caractérisé en ce que** le générateur de jet de plasma comporte une électrode (16), un canal stabilisateur (18), une tuyère formant le jet de plasma et un système d'alimentation permettant d'introduire et de contrôler le débit des gaz de protection de l'électrode et des gaz d'apport du jet de plasma.

23. Dispositif selon la revendication 21 ou 22, **caractérisé en ce que** le générateur de jet cathodique est dirigé vers la surface à traiter sous un angle α aigu.

24. Dispositif selon la revendication 21, 22, ou 23, **caractérisé en ce que** le générateur de jet anodique est dirigé vers la surface à traiter sous un angle β qui est plus grand qu'un angle α formé entre le générateur de jet cathodique et la surface à traiter.

25. Dispositif selon la revendication 24, **caractérisé en ce que** l'angle β entre le générateur de jet anodique et la surface à traiter approche, ou est essentiellement égal à 90°.

26. Dispositif selon la revendication 24 ou 25, **caractérisé en ce que** l'angle α entre le générateur de jet cathodique et la surface à traiter est entre 25° et 60°.

27. Dispositif selon l'une des revendications 21 à 26, **caractérisé en ce qu'**il comprend une série de générateurs de jets anodiques et cathodiques disposés de manière alternées dans une direction transversale à la direction de déplacement relatif de l'objet à traiter par rapport aux générateurs de plasma.

28. Dispositif selon l'une des revendications 21 à 27, **caractérisé en ce que**, dans la direction transversale à la direction v de déplacement de l'objet à traiter, les générateurs de jets cathodiques et anodiques alternent de manière que l'axe de chacun des générateurs d'un pôle donné soit équidistant des axes des deux générateurs voisins, tous deux de pôle opposé.

29. Dispositif selon la revendication 27 ou 28, **caractérisé en ce qu'**il comporte au moins deux séries de générateurs de jets de plasma disposés de part et d'autre de l'objet à traiter sous forme d'un feuille, de manière à traiter simultanément ou consécutivement les deux faces de cette feuille.

30. Dispositif selon l'une des revendications 21 à 29, **caractérisé en ce qu'**il comporte, en amont de la zone de traitement par plasma, un dispositif de stabilisation de courants d'air (10).

31. Dispositif selon la revendication 30, **caractérisé en ce que** le dispositif de stabilisation comprend un corps (33) disposé de chaque côté de la feuille à traiter formant un interstice étroit pour le passage de la feuille, et des moyens pour introduire des gaz d'apport Q dans l'interstice pour contrôler et régler le mélange gazeux dans la zone de traitement par plasma.

32. Dispositif selon l'une des revendications 21 à 31, pour le traitement de feuilles, **caractérisé en ce qu'**il comporte, en aval de la zone de traitement par plasma, un dispositif de stabilisation de courants d'air (32) comprenant un système de refroidissement.

33. Dispositif selon l'une des revendications 21 à 32, **caractérisé en ce qu'**il comporte des paliers aérodynamiques (31, 32) disposés respectivement en amont et en aval des générateurs de plasma.

34. Dispositif selon la revendication précédente, **caractérisé en ce que** le palier aérodynamique comprend un corps avec une entrée d'air (38) sous pression connectée via un collecteur (39) à des orifices de sortie (40) dirigés à contre courant du déplacement v de la feuille pour créer un coussin d'air entre la feuille et le corps du palier.

35. Dispositif selon la revendication précédente, **caractérisé en ce que** les paliers en aval sont refroidis à l'eau.

36. Dispositif selon la revendication 34 ou 35, **caractérisé en ce que** les orifices de sortie ont une forme longitudinale et sont distribuées sur la largeur de la feuille, l'angle δ que la direction longitudinale des orifices forme avec la direction de déplacement de la feuille étant proche de 0° au centre de la feuille et augmentant vers les bords latéraux de la feuille.

37. Dispositif selon la revendication 21, destiné au traitement de fils métalliques, **caractérisé en ce qu'**il comporte plusieurs séries (8') de générateurs de jets de plasma anodiques et cathodiques disposées le long du fil à traiter.

38. Dispositif selon la revendication précédente, **caractérisé en ce** chaque série comprend plusieurs paires de générateurs de jets anodique et cathodique (11a, 11b) disposées essentiellement symétriquement autour du fil à traiter.

**39.** Dispositif selon la revendication 37 ou 38, **caractérisé en ce que** chaque série est séparée du série voisin par un réacteur tubulaire (43).

**40.** Dispositif selon la revendication précédente, **caractérisé en ce que** le réacteur tubulaire est muni d'un collecteur d'entrée et de sortie des gaz d'apport réactifs, ainsi que de filières d'entrée et de sortie pour le guidage du fil lors de son passage à travers le dispositif.

**41.** Dispositif selon la revendication 21, pour le traitement de feuille ou de tôle profilée, **caractérisé en ce qu'**il comporte une série de blocs (48) de générateurs de plasma (11a, 11b) amovibles les uns par rapport aux autres de façon à permettre aux blocs d'épouser une surface complexe.

**42.** Dispositif selon la revendication précédente, **caractérisé en ce que** le bloc comprend un capteur pour contrôler la distance entre le bloc et la surface à traiter et pour commander un moteur pour déplacer le bloc.

**43.** Dispositif selon la revendication 41 ou 42, **caractérisé en ce que** le bloc comprend un boîtier ayant une partie d'embouchure (50) munie d'un circuit de refroidissement (51) pour stabiliser le jet de plasma et de l'envelopper d'un courant stabilisant de gaz pour comprimer le plasma (15) contre la surface à traiter.

**Patentansprüche**

**1.** Verfahren zur atmosphärischen Plasmabehandlung eines zu behandelnden Gegenstandes (2) aus elektrisch leitendem Material, umfassend die Erzeugung von Plasmastrahlen (15) durch Plasmageneratoren (11), die Anwendung der Plasmastrahlen auf eine zu behandelnde Oberfläche des zu behandelnden Gegenstandes und die Relativbewegung des zu behandelnden Gegenstandes bezüglich der Plasmageneratoren, **dadurch gekennzeichnet, dass** zumindest einer der Plasmastrahlen ein kathodischer Strahl (15a) und zumindest einer der Plasmastrahlen ein anodischer Strahl (15b) ist, wobei der anodische Strahl in einer Zone der Behandlung in der Nähe des kathodischen Strahles auf die zu behandelnde Oberfläche gerichtet wird und der elektrische Strom für die Erzeugung des kathodischen und anodischen Plasmastrahls in drei Teile unterteilt ist, von denen einer $I_3$ durch den zu behandelnden Gegenstand fliesst und die anderen beiden $I_1$, $I_2$ dazu dienen, den anodischen und kathodischen Plasmastrahl zu versorgen.

**2.** Verfahren nach Anspruch 1, **dadurch gekennzeichnet, dass** der kathodische Strahl mit der zu behandelnden Oberfläche einen spitzen Winkel $\alpha$ bildet.

**3.** Verfahren nach Anspruch 1 oder 2, **dadurch gekennzeichnet, dass** der anodische Strahl mit der zu behandelnden Oberfläche einen Winkel $\beta$ bildet, der grösser als ein Winkel $\alpha$ ist, der zwischen dem kathodischen Strahl und der zu behandelnden Oberfläche gebildet wird.

**4.** Verfahren nach Anspruch 3, **dadurch gekennzeichnet, dass** sich der Winkel $\beta$ zwischen dem anodischen Strahl und der zu behandelnden Oberfläche 90° nähert oder im Wesentlichen gleich 90° ist.

**5.** Verfahren nach Anspruch 2, 3 oder 4, **dadurch gekennzeichnet, dass** der zwischen dem kathodischen Strahl und der zu behandelnden Oberfläche gebildete Winkel $\alpha$ zwischen 25° und 60° beträgt.

**6.** Verfahren nach einem der vorangehenden Ansprüche, **dadurch gekennzeichnet, dass** es die Erzeugung einer Serie von anodischen Strahlen und kathodischen Strahlen umfasst, die alternierend in einer Richtung quer zur Richtung der Relativbewegung des zu behandelnden Gegenstandes bezüglich der Plasmageneratoren angeordnet sind.

**7.** Verfahren nach einem der vorangehenden Ansprüche, **dadurch gekennzeichnet, dass** die Pulse der kathodischen Strahlen eine höhere Leistung als die der anodischen Strahlen besitzen.

**8.** Verfahren nach einem der vorangehenden Ansprüche, **dadurch gekennzeichnet, dass** ein durch den zu behandelnden Gegenstand mitgerissener Luft- oder Gasstrom stromauf von der Behandlungszone von der zu behandelnden Oberfläche abgelöst wird.

9. Verfahren nach einem der vorangehenden Ansprüche, **dadurch gekennzeichnet, dass** ein durch den zu behandelnden Gegenstand mitgerissener Gasstrom stromab von der Behandlungszone laminarisiert wird.

10. Verfahren nach einem der vorangehenden Ansprüche, **dadurch gekennzeichnet, dass** die Plasmastrahlen in einem spitzen Winkel γ zur Richtung der Relativbewegung v des zu behandelnden Gegenstandes bezüglich der Plasmageneratoren geneigt sind.

11. Verfahren nach einem der vorangehenden Ansprüche, **dadurch gekennzeichnet, dass** der zu behandelnde Gegenstand in Gestalt einer Folie vorliegt.

12. Verfahren nach dem vorangehenden Anspruch, **dadurch gekennzeichnet, dass** Plasmastrahlen zu beiden Seiten der Folie angeordnet sind.

13. Verfahren nach dem vorangehenden Anspruch, **dadurch gekennzeichnet, dass** die auf einer der Seiten der Folie angeordneten Plasmastrahlen gegenüber den Plasmastrahlen auf der anderen Seite der Folie versetzt angeordnet sind.

14. Verfahren nach einem der vorangehenden Ansprüche, **dadurch gekennzeichnet, dass** der zu behandelnde Gegenstand in Gestalt eines Drahtes (2') vorliegt.

15. Verfahren nach einem der vorangehenden Ansprüche, **dadurch gekennzeichnet, dass** ein oder mehrere Strahlen von Zusatzgas Q so auf die Plasmastrahlen gerichtet werden, dass die Plasmastrahlen aufgeweitet und gegen den zu behandelnden Gegenstand gedrückt werden.

16. Verfahren nach einem der vorangehenden Ansprüche, **dadurch gekennzeichnet, dass** während der Einwirkung des Plasmas an dem zu behandelnden Gegenstand akustische oder Ultraschallvibrationen erzeugt werden.

17. Verfahren nach dem vorangehenden Anspruch, **dadurch gekennzeichnet, dass** die akustischen oder Ultraschallvibrationen durch einen Prozess des Anwachsens der Plasmaerzeugung durch elektrische Strompulse erzeugt werden, bei dem die Dauer der Vorderflanke der elektrischen Stromversorgungspulse genügend kurz ist, so dass das Anwachsen der Stromamplitude isochor erfolgt.

18. Verfahren nach dem vorangehenden Anspruch, **dadurch gekennzeichnet, dass** die Frequenz der elektrischen Stromversorgungspulse der Frequenz der akustischen Vibrationen nahe oder gleich ist.

19. Verfahren nach einem der vorangehenden Ansprüche, **dadurch gekennzeichnet, dass** ein magnetisches Wechselfeld dergestalt erzeugt wird, dass die sich ergebenden Stromkräfte eine überstreichende Schwingung der Plasmastrahlen hervorrufen.

20. Verfahren nach dem vorangehenden Anspruch, **dadurch gekennzeichnet, dass** die Schwingungsfrequenz v des magnetischen Feldes gleich dem Verhältnis der Relativgeschwindigkeit des zu behandelnden Gegenstandes zum Durchmesser der Plasmastrahlen oder grösser als dieses Verhältnis ist.

21. Vorrichtung zur Umsetzung des Verfahrens nach einem der vorangehenden Ansprüche, zumindest einen kathodischen Plasmastrahlgenerator (11a) und zumindest einen anodischen Plasmastrahlgenerator (11b), die so angeordnet sind, dass der anodische Strahl in einer Zone der Behandlung in der Nähe des kathodischen Strahles an die zu behandelnde Oberfläche angelegt wird, sowie einen elektrischen Stromkreis (12) zur Versorgung der Plasmastrahlen umfassend, wobei eine Schleife des elektrischen Stromkreises durch einen Abschnitt des zu behandelnden Gegenstandes geschlossen wird und Mittel umfasst, um den durch den zu behandelnden Gegenstand fliessenden Strom $I_3$ regeln zu können.

22. Vorrichtung nach Anspruch 21, **dadurch gekennzeichnet, dass** der Plasmastrahlgenerator eine Elektrode (16), einen stabilisierenden Kanal (18), eine den Plasmastrahl formende Düse sowie ein Versorgungssystem umfasst, mit dem Schutzgase für die Elektrode und Zusatzgase für den Plasmastrahl eingeführt werden können und ihr Strom kontrolliert werden kann.

23. Vorrichtung nach Anspruch 21 oder 22, **dadurch gekennzeichnet, dass** der Generator des kathodischen Strahles unter einem spitzen Winkel α auf die zu behandelnde Fläche gerichtet wird.

**24.** Vorrichtung nach Anspruch 21, 22 oder 23, **dadurch gekennzeichnet, dass** der Generator des anodischen Strahles unter einem Winkel β, der grösser als ein zwischen dem Generator des kathodischen Strahles und der zu behandelnden Oberfläche gebildeter Winkel α ist, auf die zu behandelnde Oberfläche gerichtet wird.

**25.** Vorrichtung nach Anspruch 24, **dadurch gekennzeichnet, dass** sich der Winkel β zwischen dem Generator des anodischen Strahls und der zu behandelnden Oberfläche 90° nähert oder im Wesentlichen gleich 90° ist.

**26.** Vorrichtung nach Anspruch 24 oder 25, **dadurch gekennzeichnet, dass** der zwischen dem Generator des kathodischen Strahls und der zu behandelnden Oberfläche gebildete Winkel α zwischen 25° und 60° beträgt.

**27.** Vorrichtung nach einem der Ansprüche 21 bis 26, **dadurch gekennzeichnet, dass** sie eine Serie von Generatoren von anodischen und kathodischen Strahlen umfasst, die alternierend in einer Richtung quer zur Richtung der Relativbewegung des zu behandelnden Gegenstandes bezüglich der Plasmageneratoren angeordnet sind.

**28.** Vorrichtung nach einem der Ansprüche 21 bis 27, **dadurch gekennzeichnet, dass** in der Richtung quer zur Bewegungsrichtung v des zu behandelnden Gegenstandes die Generatoren der kathodischen und anodischen Strahlen so alternieren, dass die Achse jedes Generators einer gegebenen Polarität von den Achsen der beiden benachbarten Generatoren, beide von entgegengesetzter Polarität, den gleichen Abstand hat.

**29.** Vorrichtung nach Anspruch 27 oder 28, **dadurch gekennzeichnet, dass** sie zumindest zwei Serien von Plasmastrahlgeneratoren umfasst, die so zu beiden Seiten des zu behandelnden Gegenstandes in Gestalt einer Folie angeordnet sind, dass die beiden Seiten dieser Folie gleichzeitig oder nacheinander behandelt werden.

**30.** Vorrichtung nach einem der Ansprüche 21 bis 29, **dadurch gekennzeichnet, dass** sie stromauf von der Plasmabehandlungszone eine Vorrichtung (10) zur Stabilisierung der Luftströme umfasst.

**31.** Vorrichtung nach Anspruch 30, **dadurch gekennzeichnet, dass** die Stabilisierungsvorrichtung einen Körper (33), der auf jeder Seite der zu behandelnden Folie angeordnet ist und einen engen Zwischenraum für den Durchgang der Folie bildet, sowie Mittel umfasst, um Zusatzgase Q in den Zwischenraum einzubringen, um das Gasgemisch in der Plasmabehandlungszone zu kontrollieren und einzustellen.

**32.** Vorrichtung gemäss einem der Ansprüche 21 bis 31 für die Behandlung von Folien, **dadurch gekennzeichnet, dass** sie stromab von der Plasmabehandlungszone eine Vorrichtung (32) zur Stabilisierung der Luftströme aufweist, die ein Kühlsystem umfasst.

**33.** Vorrichtung nach einem der Ansprüche 21 bis 32, **dadurch gekennzeichnet, dass** sie aerodynamische Lager (31, 32) aufweist, die stromauf bzw. stromab von den Plasmageneratoren angeordnet sind.

**34.** Vorrichtung nach dem vorangehenden Anspruch, **dadurch gekennzeichnet, dass** das aerodynamische Lager einen Körper mit einem Drucklufteintritt (38) umfasst, der über einen Verteiler (39) mit Austrittslöchern (40) verbunden ist, die im Gegenstrom zur Bewegung v der Folie ausgerichtet sind, um ein Luftkissen zwischen der Folie und dem Lagerkörper zu schaffen.

**35.** Vorrichtung nach dem vorangehenden Anspruch, **dadurch gekennzeichnet, dass** die stromab gelegenen Lager wassergekühlt sind.

**36.** Vorrichtung nach Anspruch 34 oder 35, **dadurch gekennzeichnet, dass** die Austrittslöcher eine längliche Gestalt haben und über die Breite der Folie verteilt sind, wobei der Winkel δ, den die Längsrichtung der Löcher mit der Vorschubrichtung der Folie bildet, nahe 0° im Zentrum der Folie ist und zu den Seitenkanten der Folie hin zunimmt.

**37.** Vorrichtung nach Anspruch 21, für die Behandlung von Metalldrähten bestimmt, **dadurch gekennzeichnet, dass** sie mehrere Serien (8') von anodischen und kathodischen Plasmastrahlgeneratoren umfasst, die entlang des zu behandelnden Drahtes angeordnet sind.

**38.** Vorrichtung nach dem vorangehenden Anspruch, **dadurch gekennzeichnet, dass** jede Serie mehrere Paare von anodischen und kathodischen Strahlgeneratoren (11a, 11b) umfasst, die im Wesentlichen symmetrisch um den zu behandelnden Draht herum angeordnet sind.

**39.** Vorrichtung nach Anspruch 37 oder 38, **dadurch gekennzeichnet, dass** jede Serie von der benachbarten Serie durch einen röhrenförmigen Reaktor (43) getrennt ist.

**40.** Vorrichtung nach dem vorangehenden Anspruch, **dadurch gekennzeichnet, dass** der röhrenförmige Reaktor mit einem Eintritts- und einem Austrittsverteiler für die reaktiven Zusatzgase sowie mit Eintritts- und Austrittsdüsen für die Führung des Drahtes bei seinem Durchgang durch die Vorrichtung ausgerüstet ist.

**41.** Vorrichtung nach Anspruch 21 für die Behandlung von Folien oder Profilblech, **dadurch gekennzeichnet, dass** sie eine Serie von Blöcken (48) von Plasmageneratoren (11a, 11b) umfasst, die so zueinander bewegt werden können, dass die Blöcke sich einer komplizierten Oberfläche anpassen können.

**42.** Vorrichtung nach dem vorangehenden Anspruch, **dadurch gekennzeichnet, dass** der Block einen Fühler umfasst, um den Abstand des Blocks von der zu behandelnden Oberfläche zu kontrollieren und einen Motor für die Verschiebung des Blocks zu steuern.

**43.** Vorrichtung nach Anspruch 41 oder 42, **dadurch gekennzeichnet, dass** der Block ein Gehäuse umfasst, das einen mit einem Kühlkreis (51) versehenen Mündungsabschnitt (50) hat, um den Plasmastrahl zu stabilisieren und ihn mit einer stabilisierenden Gasströmung zu umhüllen, die das Plasma 15 gegen die zu behandelnde Oberfläche drückt.

**Claims**

**1.** A process for the treatment with an atmospheric plasma of an object to be treated (2), made of an electrically conductive material, including the generation of plasma jets (15) by plasma generators (11), the application of the plasma jets to a surface to be treated of the object to be treated, and the relative displacement of the object to be treated relative to the plasma generators, **characterised in that** at least one of the plasma jets is a cathodic jet (15a) and at least one of the plasma jets (15b) is an anodic jet, said anodic jet being applied to a treatment zone on said surface to be treated in the proximity of the cathodic jet, the electrical current for the generation of the cathodic and of the anodic plasma jets being divided into three parts, one, $I_3$, flowing through the object to be treated and the two others, $I_1$, $I_2$, being fed to the anodic and to the cathodic plasma jets.

**2.** A process according to claim 1, **characterised in that** the cathodic jet forms with the surface to be treated an acute angle $\alpha$.

**3.** A process according to claim 1 or 2, **characterised in that** the anodic jet forms with the surface to be treated, an angle $\beta$ which is greater than the angle $\alpha$ formed between the cathodic jet and the surface to be treated.

**4.** A process according to claim 3, **characterised in that** the angle $\beta$ between the anodic jet and the surface to be treated approaches or is substantially equal to 90 °.

**5.** A process according to claim 2, 3 or 4, **characterised in that** the angle $\alpha$ between the cathodic jet and the surface to be treated is between 25 ° and 60 °.

**6.** A process according to one of the preceding claims, **characterised in that** it includes the generation of a series of anodic jets and of cathodic jets, arranged alternately in a transverse direction with respect to the direction of the motion of the object to be treated relative to the plasma generators.

**7.** A process according to one of the preceding claims, **characterised in that** the impulse received by the cathodic jets is more highly powered than that received by the anodic jets.

**8.** A process according to one of the preceding claims, **characterised in that** a flow of air or of gas, dragged along by the object to be treated, is separated from the surface to be treated upstream of the treatment zone.

**9.** A process according to one of the preceding claims, **characterised in that** a flow of gas dragged by the object to be treated is made laminar, upstream of the treatment zone.

**10.** A process according to one of the preceding claims, **characterised in that** the plasma jets are oriented at an acute angle γ with respect to the direction of motion v of the object to be treated, relative to the plasma generators.

11. A process according to one of the preceding claims, **characterised in that** the object to be treated is in the form of a foil.

12. A process according to the preceding claim, **characterised in that** the plasma jets are positioned on the two sides of the foil.

13. A process according to the preceding claim, **characterised in that** the plasma jets on one of the sides of the foil are arranged in such a manner as to be offset with respect to the plasma jets on the other side of the foil.

14. A process according to one of the preceding claims, **characterised in that** the objet to be treated is in the form of a wire (2').

15. A process according to one of the preceding claims, **characterised in that** one or several jets of additional gas Q is or are directed onto the plasma jets, in order to widen or compress the plasma jets directed against the object to be treated.

16. A process according to one of the preceding claims, **characterised in that** an acoustic or an ultrasonic vibration is generated on the object to be treated, during the action of the plasma.

17. A process according to the preceding claim, **characterised in that** the acoustic or the ultrasonic vibration is created by a process of plasma generation through supplied electrical pulses, wherein the duration of the leading edge of the magnitude of the supplied electrical current pulses is sufficiently short to enable the process of increase of the magnitude of the current to be isochoric.

18. A process according to the preceding claim, **characterised in that** the frequency of the electrical current pulses is close or equal to the frequency of the acoustic vibrations.

19. A process according to one of the preceding claims, **characterised in that** an alternating magnetic field is generated in such a manner that the resulting Ampere forces produce a sweeping oscillation of the plasma jets.

20. A process according to the preceding claim, **characterised in that** the frequency ν of the oscillations of the magnetic field is equal to, or greater, than the ratio of the relative speed of motion of the object to be treated to the diameter of the plasma jets.

21. A device for carrying out the process according to one of the preceding claims, **characterised in that** it includes at least one cathodic plasma jet generator (11a) and at least one anodic plasma jet generator (11b), arranged in such a manner that the anodic jet is applied to a treatment zone of the surface to be treated, in the proximity of the cathodic jet, and an electrical circuit (12) for supplying the plasma jets, a loop of the electrical circuit being closed by a portion of the object to be treated and including a means for varying the electrical current $I_3$ flowing through the object to be treated.

22. A device according to claim 21, **characterised in that** the plasma jet generator includes an electrode (16), a stabilising channel (18), a nozzle for forming the plasma jet and a supply system which makes it possible to introduce and to control the flow, of the gas protecting the electrode and of the additional gases brought to the plasma jet.

23. A device according to claim 21 or 22, **characterised in that** the cathodic jet generator is directed on the surface to be treated under an angle α which is acute.

24. A device according to claim 21, 22 or 23, **characterised in that** the anodic jet generator is directed to the surface to be treated at an angle β which is greater than the angle α between the cathodic jet generator and the surface to be treated.

25. A device according to claim 24, **characterised in that** the angle β between the anodic jet generator and the surface to be treated approaches or is substantially equal to 90°.

26. A device according to claim 24 or 25, **characterised in that** the angle α between the cathodic jet generator and the surface to be treated is between 25 ° and 60°.

27. A device according to one of the claims 21 to 26, **characterised in that** it includes a series of anodic and cathodic jet generators placed alternately in a transverse direction with respect to the direction of the motion of the object to be treated, relative to the plasma generators.

28. A device according to one of the claims 21 to 27, **characterised in that**, in the direction which is transverse with respect to the direction of motion v of the object to be treated, the cathodic and the anodic jet generators alternate in such a manner that the axis of each one of the generators of a given polarity is at an equal distance from the axes of the two neighbouring generators, both of the opposite polarity.

29. A device according to claim 27 or 28, **characterised in that** it includes, at least, two series of plasma jet generators arranged on both sides of the object to be treated, which is in the form of a foil, in such a manner as to treat, simultaneously or sequentially, the two faces of this foil.

30. A device according to one of claims 21 to 29, **characterised in that** it includes, upstream of the plasma treatment zone, a device (10) for stabilising the air flow.

31. A device according to claim 30, **characterised in that** the stabilisation device includes a body (33) positioned on each side of the foil to be treated to form a narrow gap for the passage of the foil, and means for introducing additional gases Q into the gap, in order to control and adjust the gas mixture in the plasma treatment zone.

32. A device according to one of claims 21 to 31 for the treatment of foils, **characterised in that** it includes downstream of the plasma treatment zone, a device (32) for stabilising the air flow including a cooling system.

33. A device according to one of claims 21 to 32, **characterised in that** it includes aerodynamic bearings (31, 32) arranged, respectively, upstream and downstream of the plasma generators.

34. A device according to the preceding claim, **characterised in that** the aerodynamic bearing includes a body with a pressurised air inlet (38), connected via a manifold (39), to outflow orifices (40) directed counter-currently with respect to the motion v of the foil, to create an air cushion between the foil and the body of the bearing.

35. A device according to the preceding claim, **characterised in that** the downstream bearings are cooled with water.

36. A device according to claim 34 or 35, **characterised in that** the outflow orifices have a longitudinal shape and are distributed along the width of the foil, the angle $\delta$ of the longitudinal direction of the orifices with the direction of motion of the foil being close to 0 ° at the centre of the foil and increasing towards the side edges of the foil.

37. A device according to claim 21, designed for the treatment of wires, **characterised in that** it includes several series (8') of anodic and cathodic plasma jets generators, arranged along the wire to be treated.

38. A device according to the preceding claim, **characterised in that** each series includes several pairs of anodic and of cathodic jet generators(11a, 11b) arranged substantially symmetrically about the wire to be treated.

39. A device according to claim 37 or claim 38, **characterised in that** each series is separated from the neighbouring series by a tubular reactor (43).

40. A device according to the preceding claim, **characterised in that** the tubular reactor is provided with a manifold for the supply and with a manifold for the discharge of the additional reactive gases, as well as with inlet and outlet guides for guiding the wire during its passage through the device.

41. A device according to claim 21 for the treatment of a foil or of a profiled sheet, **characterised in that** it includes a series of blocks (48) of plasma generators (11a, 11b) which are movable with respect to each other, in order to enable the adaptation of the blocks to a surface which is complex.

42. A device according to the preceding claim, **characterised in that** the block includes a sensor for controlling the distance between the block and the surface to be treated and for controlling the motor moving the block.

**43.** A device according to claim 41 or claim 42, **characterised in that** the block includes a housing which has an opening (50) provided with a cooling circuit (51) for stabilising the plasma jet, and which makes it possible to surround the same with a stabilising gas stream, to press the plasma 15 directed against the surface to be treated.

*FIG. 1*

*FIG. 2*

FIG. 3

FIG. 4a

FIG. 4b

FIG. 4c

FIG. 4d

FIG. 4 e

FIG. 4 f

**FIG. 5**

*Ar*

*Q2*

*11a*

*I*

*15*

*P*

*R*

*2*

*I3*

**FIG. 6**

*T3*     *T2*     *T1*

*I1*

*D*

*9*

*α*

*10* *C*    *10* *B*    *10* *A*

*I3*

*2*

**FIG. 7a**

**FIG. 7b**

**FIG. 7c**

**FIG. 7d**

**FIG. 7e**

27

FIG. 8 a

*FIG. 8 b*

FIG. 8c

FIG. 9

FIG. 10 a

FIG. 10 b

FIG. 11b

FIG. 11a

FIG. 11c

FIG. 12 a

FIG. 12 b

FIG. 13 a

FIG. 13 c

FIG. 13 b